Europäisches Patentamt

European Patent Office

Office européen des brevets

(19)

(11) **EP 1 359 608 A1**

(12) **EUROPEAN PATENT APPLICATION**
published in accordance with Art. 158(3) EPC

(43) Date of publication:
 **05.11.2003 Bulletin 2003/45**

(51) Int Cl.⁷: **H01L 21/027**, G03F 7/20,
 G02B 13/24, G02B 13/18

(21) Application number: **01272528.9**

(22) Date of filing: **25.12.2001**

(86) International application number:
 **PCT/JP01/11363**

(87) International publication number:
 **WO 02/054459 (11.07.2002 Gazette 2002/28)**

(84) Designated Contracting States:
 **AT BE CH CY DE DK ES FI FR GB GR IE IT LI LU MC NL PT SE TR**
 Designated Extension States:
 **AL LT LV MK RO SI**

(30) Priority: **28.12.2000 JP 2000403308**
 **28.02.2001 JP 2001055754**

(71) Applicant: **Nikon Corporation**
 **Tokyo 100-8331 (JP)**

(72) Inventor: **MATSUYAMA, Tomoyuki,**
 **c/o Nikon Corporation**
 **Chiyoda-ku, Tokyo 100-8331 (JP)**

(74) Representative: **Gill, David Alan**
 **W.P. Thompson & Co.,**
 **55 Drury Lane**
 **London WC2B 5SQ (GB)**

(54) **PROJECTION OPTICAL SYSTEM AND PRODUCTION METHOD THEREFOR, EXPOSURE SYSTEM AND PRODUCTION METHOD THEREFOR, AND PRODUCTION METHOD FOR MICRODEVICE**

(57)    A production method for a projection optical system capable of efficiently manufacturing a projection optical system having excellent optical characteristics with residual aberration favorably suppressed, the method comprising: a step for assembling a projection optical system; a step for measuring wavefront aberration; a step for calculating respective components of wavefront aberration by making the measurement result correspond to a Zernike function; and first and second adjusting steps for adjusting optical members in the projection optical system corresponding to respective components of the wavefront aberration obtained in the wavefront aberration calculating step. Prior to the second adjusting step, a performance prediction step for predicting performance after adjustment in the second adjusting step; and a judging step for judging based on the performance predicted in the performance prediction step are implemented.

FIG. 9

START

PROJECTION OPTICAL SYSTEM ASSEMBLING STEP — S1
- ASSEMBLE SPLIT LENS-BARREL HOUSING ONE OR A PLURALITY OF OPTICAL MEMBERS

WAVEFRONT ABERRATION MEASURING STEP — S2

WAVEFRONT ABERRATION COMPONENT CALCULATING STEP — S3
- CALCULATE WAVEFRONT ABERRATION FROM WAVEFRONT ABERRATION MEASUREMENT RESULT AND PATTERN TRANSFER RESULT, AND EXPRESS IT USING ZERNIKE COEFFICIENT

FIRST ADJUSTING STEP — S4
- CALCULATE PERFORMANCE PREDICTION VALUE AFTER ADJUSTMENT BY SIMULATION
- CALCULATE BY SIMULATION ASPHERICAL SHAPE CAPABLE OF CORRECTING RESIDUAL ABERRATION
- FORM ASPHERIC SURFACE ON OPTICAL MEMBER
- ADJUST ATTITUDE OF OPTICAL MEMBER
- REPLACE OPTICAL MEMBER

SECOND ADJUSTING STEP — S5
- ADJUST ATTITUDE OF OPTICAL MEMBER BY EXTERNAL ADJUSTMENT MECHANISM

END

EP 1 359 608 A1

**Description**

BACKGROUND ART

1. Field of the Invention

The present invention relates to a projection optical system and a production method therefor, an exposure apparatus and a production method therefor, and a production method for microdevices. More specifically, the present invention relates to a projection optical system and a production method therefor, an exposure apparatus and a production method therefor, and a production method for microdevices, suitable for use at the time of projecting an image of a pattern formed on a mask onto a substrate in a lithography process.

2. Description of the Related Art

In manufacturing microdevices such as semiconductor devices, image pickup devices, liquid crystal display devices, or thin film magnetic heads, an exposure apparatus is used, which transfers an image of a pattern formed on a mask or a reticle (hereinafter referred to as a "mask") onto a wafer or a glass plate (hereinafter referred to as a "substrate" in general terms) applied with a photosensitizer such as a photoresist. Exposure apparatus are broadly classified into static exposure type projection exposure apparatus such as a stepper, which are frequently used for manufacturing, for example, semiconductor devices on which a minute pattern is formed, and scanning exposure type projection exposure apparatus involving a step and scan method, which are frequently used for manufacturing, for example, liquid crystal display devices having a large area. Normally, these exposure apparatus have a projection optical system for transferring a pattern image of a mask onto a substrate.

Normally, the microdevices are manufactured by forming a plurality of patterns in a layer, and hence, when the microdevices are manufactured by using the exposure apparatus, it is necessary to perform accurate alignment of a pattern image of a mask to be projected, with a pattern already formed on a substrate, and project the pattern image of the mask onto the substrate with high fidelity and high resolution. Therefore, excellent optical performance is required for the projection optical system, such that aberration is favorably suppressed and high resolution can be obtained. The projection optical system provided in the exposure apparatus is designed so as to have such excellent optical performance. However, if a manufacturing error of the optical member itself such as a lens, or an error resulting from an assembly manufacturing error which occurs at the stage of installation of a plurality of optical members in manufacturing the projection optical system remains, the optical performance as designed cannot be exhibited due to the occurrence of aberration resulting from the residual error. Therefore, the projection optical system is manufactured, while performing various adjustments such as space adjustment between optical members such as lenses, so as to exhibit optical performances as designed.

The applicant of the present invention has proposed various production methods for a projection optical system having excellent imaging properties, provided in the exposure apparatus.

For example, an outline of a production method for a projection optical system disclosed in Japanese Unexamined Patent Application, *First* Publication No. Hei 10-154657 is as described below. At first, the surface shapes of optical members such as lenses provided in the projection optical system are measured, and then the optical members are assembled to obtain a projection optical system. Low-level aberration remaining in the projection optical system is measured, and the projection optical system is adjusted based on this measurement result. Thereafter, high-level aberration remaining in the projection optical system is measured, and an aspheric surface is formed on the optical member in the projection optical system for correcting the high-level aberration.

The production method for the projection optical system proposed by the applicant of the present invention in Japanese Unexamined Patent Application, First Publication No. 2000-249917 (and corresponding US Patent Application No. 691194 filed on October 19, 2000 in United States) is a production method in which a projection optical system having excellent optical characteristics can be manufactured, even if there is non-uniformity in the refractive index in the optical members provided in the projection optical system, and an outline is as described below. At first, the surface shapes of the optical members such as lenses, and optical characteristics such as refractive index distribution are measured, and then the optical members are assembled to obtain a projection optical system. Aberration remaining in the projection optical system when non-uniformity in the refractive index in the optical members provided in the projection optical system is taken into consideration, and aberration remaining in the projection optical system when non-uniformity in the refractive index is not taken into consideration are calculated by simulation, and an aspheric surface that can correct the residual aberration resulting from the non-uniformity in the refractive index is formed on the optical member in the projection optical system, to thereby correct the residual aberration resulting from the non-uniformity in the refractive index in the optical members.

Recently, a demand for micro fabrication of patterns formed on a substrate is increasing. This is because, taking as an example the manufacture of semiconductor devices, the number of semiconductor devices manufactured from one substrate is increased by microfabrication of a pattern, and as a result, production costs of the semiconductor devices can be reduced, and the semiconductor device itself can be made small. Moreover, operation frequency can be improved by microfabrication, and low energy consumption can also be achieved. Current CPUs (Central Processing Units) are manufactured with a process rule of about 0.18 μm, but production thereof with a process rule of from 0.1 to 0.13 μm is now under way, and it is expected that CPUs will be manufactured in the future with a finer process rule.

In order to form a minute pattern, it is necessary to have a shorter wavelength of illumination light which illuminates the mask at the time of exposure, and to set the numerical aperture (N. A.) of the projection optical system high. If the numerical aperture of the projection optical system is set high, it is difficult to design a projection optical system in which the aberration is favorably suppressed. Recently however, design techniques have advanced, and designing of a projection optical system having less occurrence of aberration becomes easier, even if the projection optical system has a large numerical aperture, as compared with conventional techniques. When such a projection optical system exhibiting excellent optical characteristics is manufactured, it is necessary to adjust the projection optical system with high precision. With microfabrication of the pattern however, even higher precision is required for the adjustment of the projection optical system. Therefore, with the conventional manufacturing method for a projection optical system described above, it is difficult to manufacture a projection optical system having optical characteristics as designed. Although it is not impossible to manufacture a projection optical system having optical characteristics as designed by using the conventional method, adjustment becomes complicated, manufacturing time increases, and hence producibility decreases.

In view of the above situation, it is an object of the present invention to provide a production method for a projection optical system capable of efficiently manufacturing a projection optical system having excellent optical characteristics with residual aberration favorably suppressed, and a projection optical system having excellent optical characteristics. Moreover it is an object to provide an exposure apparatus comprising a projection optical system manufactured by the production method for the projection optical system, and a production method therefor, and also to provide a production method for microdevices using the exposure apparatus.

DISCLOSURE OF INVENTION

In order to resolve the above problems, a production method for a projection optical system according to a first aspect of the present invention is a production method for a projection optical system for forming an image on a first plane on a second plane, comprising: an assembly step (S1) for obtaining a projection optical system (PL) by assembling a plurality of barrels (30a to 30e) having one or a plurality of optical members (2, 2a to 2e) respectively housed therein; a wavefront aberration measuring step (S2) for measuring wavefront aberration of the assembled projection optical system (PL); a wavefront aberration component calculating step (S3) for making the wavefront aberration measured by the wavefront aberration measuring step (S2) correspond to a predetermined function, and calculating respective components of the wavefront aberration by resolving components of the function, and an adjusting step (S4, S5) for adjusting the plurality of barrels (30a to 30e) corresponding to the respective components ofthe wavefront aberration obtained by the wavefront aberration component calculating step (S3).

In this aspect of the invention, at the time of manufacturing a projection optical system in which high optical performance is required, the wavefront aberration of the assembled projection optical system is measured, the measured wavefront aberration is made to correspond to a predetermined function, and the respective components of the wavefront aberration are calculated by resolving the components of the function, and the barrel included in the projection optical system is adjusted corresponding to the respective components of the calculated wavefront aberration. Therefore, even slight aberration remaining in the projection optical system can be easily expressed by the respective components of the wavefront aberration, and the remaining slight residual aberration can be recognized and adjusted in each unit of barrels. As a result, the residual aberration in the projection optical system can be favorably and efficiently suppressed.

A production method for a projection optical system according to a second aspect of the present invention is a production method for a projection optical system for forming an image on a first plane on a second plane, comprising: an assembly step (S1, S10, S12) for obtaining a projection optical system by assembling a plurality of optical members (2, 2a to 2e); a wavefront aberration measuring step (S14, S30) for measuring wavefront aberration of the projection optical system; a wavefront aberration component calculating step (S3, S34) for making the wavefront aberration measured by the wavefront aberration measuring step (S2) correspond to a predetermined function, and calculating respective components of the wavefront aberration by resolving the components of the function; a first and second adjusting step (S4, S5, S36 to S50, S52 to S62) for adjusting the plurality of optical members corresponding to the respective components of the wavefront aberration obtained by the wavefront aberration component calculating step, a performance prediction step (S36) executed prior to the second adjusting step for predicting the performance after the adjustment in the second adjusting step; and a judging step (S38) executed between the performance prediction step and the second adjusting step for judging the performance of the projection optical system based on the performance predicted in the performance prediction step.

In aspect of the invention, at the time of manufacturing the projection optical system in which high optical performance is required, the wavefront aberration of the assembled projection optical system is measured, the measured wavefront is made to correspond to a predetermined function, and the respective components of the wavefront aberration are calculated by resolving the components, and at least two stage adjustment is carried out when the calculated wavefront aberration is adjusted. At this time, the performance of the projection optical system after being adjusted in the later adjustment is predicted, and based on the predicted performance, it is judged whether the former adjustment is to be finished. As a result, the adjustment operation in the later adjustment is facilitated, the residual aberration is favorably suppressed, and a projection optical system having excellent optical characteristics can be efficiently manufactured.

In the production method for a projection optical system according to the second aspect of the present invention, it is preferable that the wavefront aberration measuring step includes a first wavefront aberration measuring step executed before the first adjusting step and a second wavefront aberration measuring step executed between the first adjusting step and the judging step. It is also preferable that the wavefront aberration component calculating step includes a first wavefront aberration component calculating step in which the wavefront aberration measured in the first wavefront aberration measuring step is made to correspond to the predetermined function, and a second wavefront aberration component calculating step in which the wavefront aberration measured in the second wavefront aberration measuring step is made to correspond to the predetermined function.

According to this aspect of the invention, since wavefront aberration measurement and wavefront aberration component calculation are performed both in the first and second adjusting steps, in particular, in the second adjusting step, a high-performance projection optical system can be efficiently manufactured.

In the production method for a projection optical system according to the second aspect of the present invention, it is preferable that the first adjusting step includes an aspherical shape calculating step (S46) for calculating an aspherical shape that can correct residual wavefront aberration remaining after the adjustment of the optical members (2, 2a to 2e).

According to this aspect of the invention, since the aspherical shape that can correct the residual wavefront aberration remaining after adjustment of the optical members is obtained by calculation, production efficiency can be improved as compared with a case where residual wavefront aberration is corrected in trial and error by actually forming an aspheric surface on the optical member.

Moreover, in the production method for a projection optical system according to the second aspect of the present invention, it is preferable that in the aspherical shape calculating step an aspheric surface including a non-rotational symmetrical component with respect to the optical axis of the projection optical system is calculated.

According to this aspect of the invention, when the aspherical shape that can correct the residual wavefront aberration is obtained by calculation, the aspheric surface including non-rotational symmetrical components with respect to the optical axis of the projection optical system is obtained. As a result, not only low-level aberration such as Seidel's five aberrations of the geometrical optics, but also high-level aberration can be corrected efficiently.

In the production method for a projection optical system according to the second aspect of the present invention, it is preferable to further include an aspheric surface forming step (S50) in which an aspheric surface calculated in the aspherical shape calculating step (S46) is formed on an optical surface of at least one predetermined optical member (2, 2a to 2e) of the plurality of optical members (2, 2a to 2e).

Moreover, in the production method for a projection optical system according to the second aspect of the present invention, it is preferable that in the aspherical shape calculating step, the aspherical shape is calculated in relation to the optical surfaces of at least two optical members of the plurality of optical members, and if a diameter of light (radiation) beam when the light beam from one predetermined point on the surface of an object passes through the optical surfaces is assumed to be a partial diameter of light beam, optical members having different partial diameter of light beam with respect to a clear aperture of the optical surface are selected for the at least two optical members.

According to this aspect of the invention, since an aspheric surface is formed on at least two optical members having a different ratio for the clear aperture of the optical member to the diameter of passing light beam, this is preferable when effectively correcting only specific aberration.

In the production method for a projection optical system according to the second aspect of the present invention, it is preferable that in the first adjusting step at least the attitude of the optical members (2, 2a to 2e) is adjusted, and at least one optical member (2, 2a to 2e) of the plurality of optical members (2, 2a to 2e) is replaced.

In the production method for a projection optical system according to the second aspect of the present invention, it is preferable that judgment of whether to shift to the aspherical shape calculating step when the projection optical system does not have a predetermined performance in the judging step (S38), is performed in the judging step.

In the production method for a projection optical system according to the second aspect of the present invention, it is preferable in the second adjusting step that an external adjustment mechanism (8, 32a to 32e, 35) which can adjust the performance of the projection optical system (PL) from outside of the projection optical system (PL) is used to perform adjustment.

In the production method for a projection optical system according to the second aspect of the present invention, it is preferable that the second adjusting step includes a step (S52) for determining a correlation between an adjustment amount by the external adjustment mechanism and a variation in the performance of the projection optical system (PL).

In the production method for a projection optical system according to the second aspect of the present invention, it is preferable that the second adjusting step has at least either one of a supplementary step (S62) for adjusting the attitude of the optical members (2, 2a to 2e), and a supplementary step (S62) for replacing the optical members (2, 2a to 2e) in the vicinity of the first plane and/or the second plane of the plurality of optical members (2, 2a to 2e).

In the production method for a projection optical system according to the second aspect of the present invention, it is preferable to set the wavelength of the projection optical system (PL) in the second adjusting step.

In the production method for a projection optical system according to the second aspect of the present invention, it is preferable that the second adjusting step includes a step for performing fine adjustment of the attitude of the second plane.

In the production method for a projection optical system according to the second aspect of the present invention, it is preferable that in the assembly step, a plurality of barrels (30a to 30e) in which one or a plurality of the optical members (2, 2a to 2e) is respectively housed is assembled, and in the adjusting step, the plurality of barrels (30a to 30e) are adjusted, corresponding to the respective components of the wavefront aberration obtained in the wavefront aberration component calculating step.

A production method for a projection optical system according to a third aspect of the present invention is a production method of a projection optical system for forming an image on a first plane on a second plane, comprising: an assembly step (S10, S12) for obtaining a projection optical system (PL) by assembling a plurality of optical members (2, 2a to 2e); a wavefront aberration measuring step (S30) for measuring wavefront aberration of the assembled projection optical system (PL); a wavefront aberration component calculating step (S34) for making the wavefront aberration measured by the above step to correspond to a predetermined function, and calculating respective components of the wavefront aberration by resolving the components of the function; and an adjusting step (S40 to S62) for adjusting the plurality of optical members corresponding to the respective components of the wavefront aberration obtained by the above step, wherein the adjusting step includes an aspherical shape calculation supplementary step (S46) for calculating an aspherical shape that can correct residual wavefront aberration remaining after the optical members have been adjusted, and in the aspherical shape calculation supplementary step, the aspherical shape is calculated in relation to the optical surfaces of at least two optical members (2, 2a to 2e) of the plurality of optical members, and if a diameter of light beam when the light beam from one predetermined point (Q1 or Q2) on the surface of an object (R) passes through the optical surface is assumed to be a partial diameter of light beam, optical members having different partial diameter of light beam with respect to a clear aperture of the optical surface are selected for the at least two optical members.

A production method for a projection optical system according to a fourth aspect of the present invention is a production method for a projection optical system for forming an image on a first plane on a second plane, comprising: an assembly step (S10, S12) for obtaining a projection optical system (PL) by assembling a plurality of optical members (2, 2a to 2l); a fitting step (S52) for fitting an external adjustment mechanism (32, 38, 39) which adjusts a specific optical member (2b, 2d, 2e, 2f, 2g) of the optical members (2, 2a to 2l) from outside, to the projection optical system (PL); a wavefront aberration measuring step (S54) for measuring wavefront aberration of the projection optical system (PL); a wavefront aberration component calculating step (S58) for making the wavefront aberration measured by the wavefront aberration measuring step (S54) correspond to a predetermined function, and calculating respective components of the wavefront aberration by resolving the components of the function; and a fine adjustment step (S62) for finely adjusting the performance of the projection optical system (PL) by the external adjustment mechanism (32, 38, 39), corresponding to the respective components of the wavefront aberration obtained by the wavefront aberration component calculating step (S58).

In the production method for a projection optical system according to the fourth aspect of the present invention, it is preferable that the external adjustment mechanism (32, 38, 39) adjusts one or a plurality of the specific optical members (2b, 2d, 2e, 2f, 2g), to independently adjust at least three aberrations.

Furthermore, in order to resolve the above problems, a production method for an exposure apparatus of the present invention comprises: a step for preparing a projection optical system (PL) produced by the production method for a projection optical system; a step for preparing a mask stage (16) for positioning a mask (R) on the first plane of the projection optical system (PL); and a step for preparing a substrate stage (18) for positioning a substrate (W) on the second plane of the projection optical system (PL).

Furthermore, in order to resolve the above problems, in the present invention, a projection optical system produced by the aforementioned production method is provided.

Furthermore, in order to resolve the above problems, an exposure apparatus of the present invention comprises a projection optical system (PL) produced by the production method for a projection optical system, wherein a pattern image of a mask (R) positioned on the first plane is transferred onto a substrate (W) positioned on the second plane through the projection optical system (PL).

Furthermore, in order to resolve the above problems, a production method for a microdevice of the present invention comprises: an exposure step (S96) which uses the exposure apparatus for exposing a pattern (DP) of the mask (R) on the substrate (W); and a development step (S97) for developing the substrate (W) exposed by the exposure step (S96).

BRIEF DESCRIPTION OF THE DRAWING

FIG. 1 is a diagram showing a schematic configuration of an exposure apparatus according to one embodiment of the present invention, comprising a projection optical system according to one embodiment of the present invention.

FIG. 2A is a diagram showing the sectional structure in the side direction, of an adjusting apparatus arranged at the bottom part of the projection optical system.

FIG. 2B is a diagram showing the structure on the side face of the adjusting apparatus shown in FIG. 2A.

FIG. 3 is a diagram for conceptually explaining the relation between a tilt angle of a plane-parallel plate held by a first member, and the occurrence and correction of eccentric coma aberration.

FIG. 4 is a cross-section schematically showing the configuration of an assembly apparatus used at the time of manufacturing the projection optical system according to one embodiment of the present invention.

FIG. 5 is a cross-section of a main part showing a load reduction section of the assembly apparatus.

FIG. 6 is a cross-section of a main part showing an eccentricity adjusting section of the assembly apparatus.

FIG. 7 is a diagram showing a schematic configuration of an aberration measuring apparatus using a phase restoration method.

FIG. 8 is a diagram showing a schematic configuration of wavefront aberration measuring apparatus.

FIG. 9 is a flowchart showing the outline of a production method for a projection optical system according to one embodiment of the present invention.

FIG. 10 is a flowchart showing a detailed flow of the production method for a projection optical system according to the one embodiment of the present invention.

FIG. 11 is a flowchart showing a detailed flow of the production method for a projection optical system according to the one embodiment of the present invention.

FIG. 12 is a flowchart showing a detailed flow of the production method for a projection optical system according to the one embodiment of the present invention.

FIG. 13A is a diagram for explaining the principle for correcting a center astigmatism component.

FIG. 13B is a diagram for explaining the principle for correcting a center astigmatism component.

FIG. 14 is a diagram for explaining an optical member where an aspheric surface is formed.

FIG. 15 is a flowchart showing one example of a production step of a microdevice.

FIG. 16 is a diagram showing one example of a detailed flow in step S83 shown in FIG. 15, in the case of a semiconductor device.

FIG. 17 is a flowchart showing the details of the series of steps carried out from the production of optical members installed inside split lens-barrels until the optical members are installed into the split lens-barrels.

FIG. 18 is a diagram showing the configuration of an interferometer apparatus for measuring an absolute value of the refractive index and the refractive index distribution of a block glass material.

FIG. 19A is a schematic block diagram of a central thickness measuring apparatus using a Michelson interferometer.

FIG. 19B is a diagram showing the relation between the intensity of coherent light shone onto a light-receiving element and the position of a reflection mirror.

FIG. 20 is a diagram showing a schematic configuration of a projection optical system according to a modified example of the embodiment of the present invention.

FIG. 21 is a top view showing one of the split lens-barrels in the projection optical system according to the modified example.

FIG. 22A is a diagram for explaining two kinds of eccentric distortion.

FIG. 22B is a diagram for explaining two kinds of eccentric distortion.

FIG. 22C is a diagram for explaining two kinds of eccentric distortion.

BEST MODE FOR CARRYING OUT THE INVENTION

A projection optical system and a production method therefor, an exposure apparatus and a production method therefor, and a production method for microdevices according to one embodiment of the present invention will now be described, with reference to the drawings.

[Exposure Apparatus]

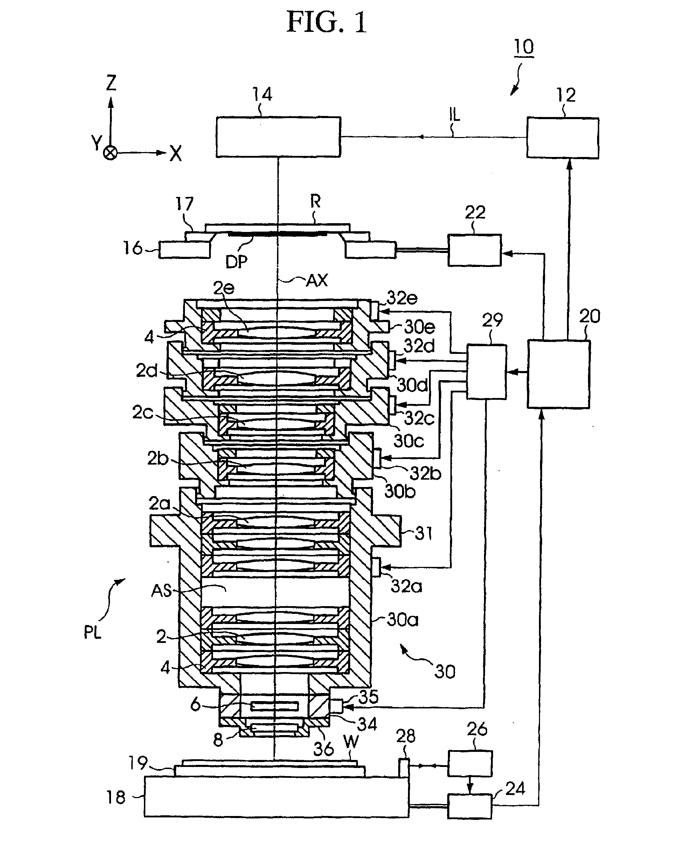

FIG. 1 is a diagram showing a schematic configuration of an exposure apparatus according to one embodiment of the present invention, comprising a projection optical system according to one embodiment of the present invention. In this embodiment, description is made for a case where the present invention is applied to an exposure apparatus 10 involving a step and repeat method, in which a reduced image of a circuit pattern DP formed on a reticle R and reduced through a projection optical system PL is transferred to a predetermined shot area, of a plurality of shot areas set on a wafer W, as shown in FIG. 1. In the following description, an XYZ rectangular coordinate system shown in FIG. 1 is established and the positions of the respective members are described with reference to the XYZ rectangular coordinate system. The XYZ rectangular coordinate system is set such that the X axis and the Y-axis are parallel with a wafer stage 18, and the Z-axis is set in a direction orthogonal to the wafer stage 18 (in a direction parallel to the optical axis AX of the projection optical system PL). The XYZ coordinate system in the figure is actually set such that the XY plane is set on a plane parallel with a horizontal plane, and the Z-axis is set in a perpendicularly upward direction.

The exposure apparatus 10 shown in FIG. 1 mainly comprises; a light source 12, an illumination optical system 14, a reticle stage 16 as a mask stage for positioning of the reticle R in the Y plane, the projection optical system PL, the wafer stage 18 as a substrate stage for shifting the wafer W within the XY plane orthogonal to the optical axis AX of the projection optical system PL (in the direction of Z-axis), and a main control system 20. In FIG. 1, the sectional structure of the projection optical system PL is shown for convenience of explanation. The light source 12 comprises, for example, a KrF excimer laser (248 nm), an ArF excimer laser (193 nm) or the like, and emits illumination light IL required at the time of exposure. The illumination optical system 14 comprises a relay lens, a fly-eye lens. a micro lens array, a diffraction grating array, an optical integrator such as an internal reflection type integrator (rod type integrator), an integrator sensor, a speckle reduction apparatus, a reticle blind for regulating the illumination area on the reticle, and the like (not shown). The illumination optical system 14 equalizes the illumination distribution of the illumination light IL emitted from the light source 12, and shapes the sectional shape of the illumination light IL.

The reticle stage 16 installed below the illumination optical system 14 (in the-Z-axis direction) holds the reticle R through a reticle holder 17. The reticle stage 16 is constituted so as to be able to move within the plane of the reticle R (within the XY plane), upon reception of a control signal from a reticle stage control unit 22, in order to position the reticle R in a predetermined position. Specifically, the reticle R is positioned so that the central point of the circuit pattern DP is located on the optical axis AX of the projection optical system PL. When the illumination light IL having a uniform illumination distribution is irradiated, the image of the circuit pattern DP formed on the reticle R is projected onto the wafer W through the projection optical system PL. The projection optical system PL is provided with a lens controller section 29 which controls so that the optical characteristics such as imaging characteristic become constant, corresponding to a change in the environment such as temperature and atmospheric pressure.

As described later, the projection optical system PL has a structure in which a plurality of lens elements 2 are arranged coaxially so as to have a common optical axis AX in the lens-barrel 30, and is arranged between the reticle R and the wafer W, so that the plane of the reticle R where the circuit pattern DP is formed and the surface of the wafer W become conjugate with respect to the optical system comprising these lens elements 2. In other words, the plane of the reticle R where the circuit pattern DP is formed is positioned on an object plane (first plane) of the projection optical system PL, and the surface of the wafer W is positioned on an image plane (second plane) of the projection optical system PL. The reduction magnification of the projection optical system PL is determined by the magnification of the optical system comprising the lens elements 2. A flange 31 for mounting the projection optical system PL on a frame (not shown) in the exposure apparatus 10 is formed on the outer circumference of the lens-barrel 30 and at the central position in the Z-axis direction.

The wafer W is held on the wafer stage 18 through the wafer holder 19. The wafer stage 18 is formed by overlapping a pair of blocks (not shown), respectively movable in the X-axis direction and the Y-axis direction in the figure, on each other, and the position thereof in the XY plane is freely adjustable. Though not shown, the wafer stage 18 comprises a Z stage for moving the wafer W in the Z-axis direction, a stage for slightly rotating the wafer W in the XY plane, and a stage for adjusting the tilt of the wafer W with respect to the XY plane by changing the angle thereof with respect to the Z-axis. A movable mirror 28 having a length of more than the movable range of the wafer stage 18 is fitted at one end on the upper face of the wafer stage 18, and a laser interferometer 26 is arranged at a position facing the mirror face of the movable mirror 28.

Though shown in a simplified manner in FIG. 1, the movable mirror 28 comprises a movable mirror having a reflecting surface perpendicular to the X-axis and a movable mirror having a reflecting surface perpendicular to the Y-axis. The laser interferometer 26 comprises two laser interferometers for the X-axis for irradiating the laser beam to the movable mirror 28 along the X-axis, and a laser interferometer for the Y-axis for irradiating the laser beam to the movable mirror 28 along the Y-axis, and the X coordinate and the Y coordinate of the wafer stage 18 are measured by one laser interferometer for the X-axis and one laser interferometer for the Y-axis. Moreover, the angle of rotation of the wafer stage 18 is measured by a difference between the measurements of the two laser interferometers for the X-axis. Furthermore, the angle of rotation of the wafer stage 18 in the XY plane is measured by a difference between the measurements of the two laser interferometers for the X-axis. The information of the X coordinate, the Y coordinate and the angle of rotation measured by the laser interferometer 26 is output to a wafer stage control system 24 as the stage position information, for controlling the attitude of the wafer W in nano-order.

The control of the intensity and the irradiation timing of the illumination light IL emitted from the light source 12, the slight movement control of the reticle stage 16, and the movement control of the wafer stage 18 are collectively controlled by the main control system 20. With the above configuration, when the reticle R is uniformly illuminated by the illumination optical system 14, the image of the circuit pattern DP formed on the reticle R is reduced corresponding to the reduction magnification of the projection optical system PL, and transferred to the shot area on the wafer W. When the exposure processing for one shot area is finished, the wafer stage 18 is step-shifted in the XY plane, so that the next shot area is located at a position conjugate with the pattern plane of the reticle R, through the projection optical system PL, to perform a similar exposure operation.

[Projection Optical System]

The schematic configuration and the operation of the exposure apparatus according to one embodiment of the present invention has been described above. Next is a description of the projection optical system according to one embodiment of the present invention, which is included in the exposure apparatus according to the one embodiment of the present invention. As shown in FIG. 1, each of the lens elements 2 is held by an annular lens frame 4 at the outer circumference thereof, and the lens frames 4 are arranged along the optical axis AX in the lens-barrel 30. The optical axis of each lens element 2 held by the lens frame 4 is arranged so as to become coaxial with the optical axis AX of the projection optical system PL. The lens-barrel 30 has split lens-barrels 30a to 30e, and one or a plurality of lens elements 2 is housed in the respective split lens-barrels 30a to 30e. The split lens-barrel 30a is provided with a plurality of lens elements 2a and an aperture stop AS. The split lens-barrels 30b to 30e are respectively provided with lens elements 2b to 2e. As described above, not only the lens elements 2a to 2e, but also the aperture stop AS and one or a plurality of optical members (not shown) for correcting aberration is installed in the split lens-barrels 30a to 30e. The lens-barrel 30 shown in FIG. 1 has five split lens-barrels, but the number of the split lens-barrels is not limited to five. Moreover, in the lens-barrel 30 in FIG. 1, there is only one split lens-barrel (30a) arranged below the flange 31 for supporting the lens-barrel 30, but this portion may be formed of a plurality of lens-barrels.

Furthermore, adjusting members 32a to 32e are provided on the split lens-barrels 30a to 30e, as an external adjustment mechanism for adjusting the residual aberration of the projection optical system PL from outside of the lens-barrel 30, after the assembly of the projection optical system PL. According to the adjusting members 30a to 30e, it is possible to adjust the attitude of the optical members (not shown), including the position thereof in the direction of the optical axis AX, the position (eccentricity) thereof in the plane orthogonal to the optical axis AX, the rotational position thereof about an axis orthogonal to the optical axis AX, and the rotational position thereof about the optical axis AX. The respective adjusting members 32a to 32e have movable members, such as three actuators and piezo elements fitted to the side wall of the split lens-barrels 30a to 30d at an angle of 120 degrees within the plane orthogonal to the optical axis AX of the projection optical system PL, and the attitude adjustment described above becomes possible by expansion and contraction of the movable members. The adjusting members 32a to 32e are also provided with a displacement sensor for measuring the amount of expansion and contraction of the movable members. The attitude due to the adjusting members 32a to 32e is controlled by a lens controller 29.

An adjusting apparatus 34 for adjusting the residual aberration of the projection optical system PL is provided below the projection optical system PL. The adjusting apparatus 34 comprises a plane parallel plate 6 for correcting the spherical aberration occurring in the lens-barrel 30 of the projection optical system PL, arranged between the split lens-barrel 30a provided in the projection optical system PL and the wafer W. This plane parallel plate 6 is arranged substantially perpendicularly to the optical axis AX of the projection optical system PL, and can be appropriately moved by a parallel plate drive 35. This parallel plate drive 35 controls a tilt angle of the plane parallel plate 6 with respect to the plane (XY plane) perpendicular to the optical axis AX, under control of the lens controller 29.

The parallel plate drive 35 slightly tilts the plane parallel plate 6 from the plane perpendicular to the optical axis AX, so that only eccentric coma aberration that has occurred in the lens-barrel 30 can be corrected independently. In other words, by adjusting at least one of the tilt angle between the normal of the plane parallel plate 6 and the optical axis AX, and the tilt direction of the plane parallel plate 6, only the eccentric coma aberration of the projection optical system PL can be independently corrected separately from other spherical aberration or the like. At the time of correction of aberration by the external adjustment mechanism 32 and the adjusting apparatus 34, readjustment is carried out appropriately corresponding to variations in the exposure conditions of the wafer W. Specifically, when the size and shape of a secondary light source and a deformed illumination are assumed to be the exposure conditions, and at least one of the shape and size of the deformed illumination, the kind of the circuit pattern DP formed on the reticle R, and the numerical aperture of the projection optical system PL is changed, the external adjustment mechanism 32 and the adjusting apparatus 34 (parallel plate drive 35) are driven to perform adjustment for aberration of the projection optical system. The deformed illumination mentioned above is, for example, an illumination in which zone deformed illumination or the coherency σ of the illumination (σ value = numerical aperture on the exit side of the illumination optical system / numerical aperture on the incidence side of the projection optical system) is changed, or a multipolar illumination in which the illumination light is divided in a multipole form (for example, four poles).

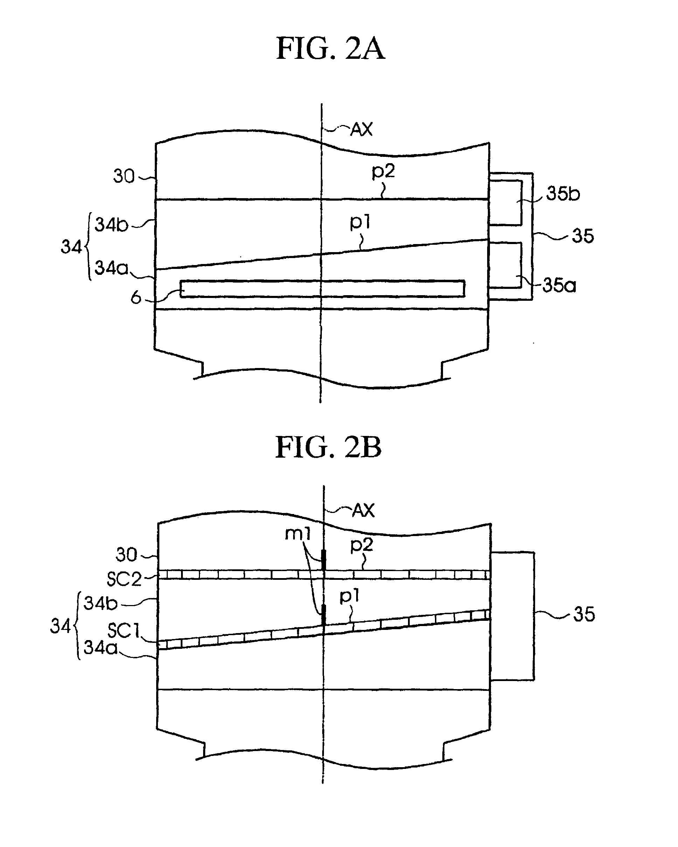

FIG. 2A and FIG. 2B are diagrams for explaining the structure of the adjusting apparatus 34 arranged at the bottom end of the projection optical system PL. FIG. 2A is a diagram schematically showing the sectional structure in the side direction of the adjusting apparatus 34, and FIG. 2B is a diagram showing the structure on the side face of the adjusting apparatus 34. The adjusting apparatus 34 comprises a first member 34a, being metal fittings for holding and fixing the plane parallel plate 6 therein, and a second member 34b, being metal fittings arranged between the first member 34a and the lens-barrel 30. The first member 34a and the second member 34b are slidably connected through a smooth plane p1, which slightly tilts from a plane perpendicular to the optical axis AX, and by relatively rotating the first member 34a and the second member 34b about the optical axis AX, the tilt angle of the normal of the plane parallel plate 6 with respect to the optical axis AX can be adjusted. The tilt angle between the optical axis AX and the smooth plane p1 is set to half the maximum tilt angle of the normal of the plane parallel plate 6 with respect to the optical axis AX. In other words, the tilt angle of the normal of the plane parallel plate 6 with respect to the optical axis AX becomes twice the tilt angle between the optical axis AX and the smooth plane p1 by rotating the first member 34a of 180 degrees toward the second member 34b in the state shown in figure.

The second member 34b and the lens-barrel 30 are slidably connected through a smooth plane p2 perpendicular to the optical axis AX, and by relatively rotating the second member 34b and the lens-barrel 30 about the optical axis AX, the tilt angle of the normal of the plane parallel plate 6 with respect to the optical axis AX can be adjusted. The relative rotational position between the first member 34a and the second member 34b can be visually detected by reading a graduated circle SC1 provided on the circumference at the upper end of the first member 34a with an index m1 provided at one place at the bottom end of the second member 3b. Moreover, the relative rotational position between the second member 34b and the lens-barrel 30 can be visually detected by reading a graduated circle SC2 provided on the circumference at the upper end of the second member 34b with an index ml provided at one place at the bottom end of the lens-barrel 30. A first driving section 35a provided in the parallel plate drive 35 adjusts the relative rotational position of the first member 34a and the second member 34b, to thereby tilt the plane parallel plate 6 by a desired angle from a plane perpendicular to the optical axis AX. As a result, only the eccentric coma aberration in a specific direction occurring in the lens-barrel 30 can be independently corrected. On the other hand, a second driving section 35b adjusts the relative rotational position of the second member 34b and the lens-barrel 30, to thereby appropriately set the tilt direction of the plane parallel plate 6. As a result, the correction direction of the eccentric coma aberration can be adjusted. The relative rotational position between the first member 34a and the second member 34b, and the relative rotational position between the second member 34b and the lens-barrel 30 may be electrically detected by monitoring the driven quantity thereof by the both driving sections 35a and 35b. For example, by detecting the relative rotational position between the first member 34a and the second member 34b based on the driven quantity of the driving section 35a, the rotational position can be converted to the tilt angle of the first member 34a.

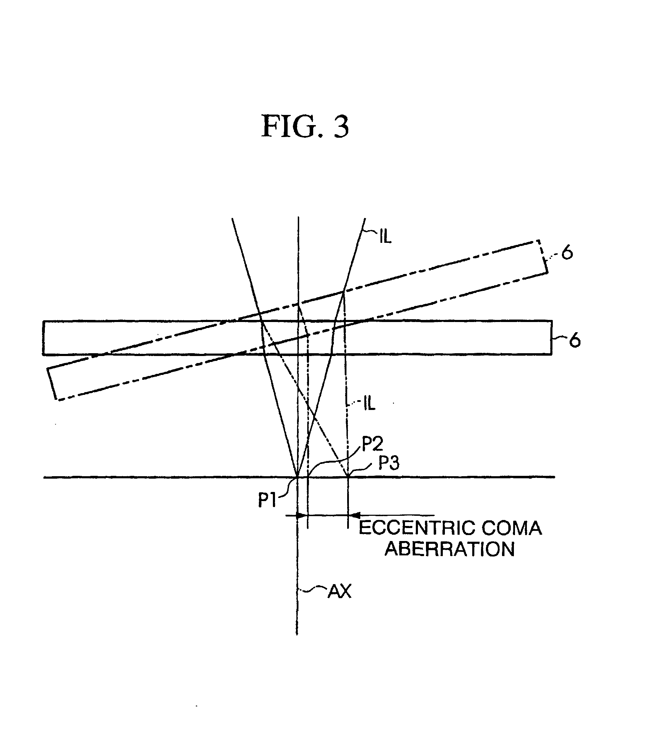

FIG. 3 is a diagram for conceptually explaining the relation between the tilt angle of the plane-parallel plate 6 held by the first member 34a, and the occurrence and correction of the eccentric coma aberration. For example, it is assumed that when the plane parallel plate 6 and the wafer W are parallel with each other as shown by a solid line in FIG. 3, the illumination light IL from the lens-barrel 30 is formed at point P1 on the wafer W. If the plane parallel plate 6 is slightly tilted from this state as shown by the two-dot chain line, the illumination light IL is not formed at point P1 due to the eccentric coma aberration. Specifically, the light traveling along the optical axis AX, of the illumination light IL, moves in a parallel direction due to the plane parallel plate 6, and is formed at point P2 in the vicinity of point P1. The light traveling at an angular aperture of the illumination light IL moves in a parallel direction due to a relatively large action of the plane parallel plate 6, and is formed at point P3 away from P1 as compared with P2. In other words, even if the eccentric coma aberration does not occur due to the lens-barrel 30, the eccentric coma aberration occurs by tilting the plane parallel plate 6. This means that when the eccentric coma aberration has occurred initially, as in the illumination light IL shown by the two-dot chain line, the eccentric coma aberration can be corrected by rotating the plane parallel plate 6 in the clockwise direction. Refer for example to US Patent No. 6,235,438 for details of this adjusting apparatus 34. The disclosure in US Patent No. 6,235,438 is hereby incorporated by reference.

Returning to FIG. 1, a glass frame 36 is screwed onto the bottom end of the adjusting apparatus 34, and a glass plate 8 having a curved surface is fitted in the glass frame 36. By changing the thickness of the glass plate 8, the optical length from the bottom end of the projection optical system PL to the wafer W can be changed to adjust the spherical aberration. Moreover, if the projection optical system PL does not satisfy Petzval's condition, thus causing image field distortional aberration, image field distortion of the projection optical system PL can be adjusted by changing the radius of curvature of the glass plate 8. Petzval's condition here is a condition for not causing the image field distortion, the sum of Petzval becoming 0. In order to change the sum of Petzval, it is necessary to change the focal length of the projection optical system PL. For that purpose, it is convenient to prepare a plurality of glass frames 36, to which glass plates 8 having various kinds of thickness and radius of curvature are fitted, in advance, and replace the glass frame 36 at the time of adjusting the spherical aberration and the image field aberration. Since only the glass frame 36 needs to be replaced at the time of adjusting the aberration due to the glass plate 8, it is not necessary to disassemble the projection optical system PL. Refer for example to Japanese Unexamined Patent Application, First Publication No. Hei 9-329742, for details of the setting method for the thickness and radius of curvature of the glass plate 8.

The configurations of the exposure apparatus and the projection optical system according to the one embodiment of the present invention have been described above. Next is a description in sequence of; an assembly apparatus used at the time of manufacturing the projection optical system PL, an aberration measuring apparatus using the phase restoration method, and a wavefront aberration measuring apparatus for measuring the wavefront aberration. Either of the aberration measuring apparatus using a phase restoration method and the wavefront aberration measuring apparatus for measuring the wavefront aberration is a measuring apparatus for measuring the wavefront aberration, but in order to discriminate these from each other, the former apparatus is simply referred to as an "aberration measuring apparatus", and the latter is referred to as a "wavefront aberration measuring apparatus". In this embodiment, the "aberration measuring apparatus" and the "wavefront aberration measuring apparatus" are used for measuring the residual aberration of the projection optical system PL. This is because the measurement accuracy of the "wavefront aberration measuring apparatus" is higher than that of the "aberration measuring apparatus", and hence, in the production process for the projection optical system PL, the "aberration measuring apparatus" is used to reduce the residual aberration of the projection optical system PL to some extent, and thereafter the "wavefront aberration measuring apparatus" having higher measurement accuracy is used to perform measurement, and produce the projection optical system PL having less residual aberration.

[Assembly Apparatus]

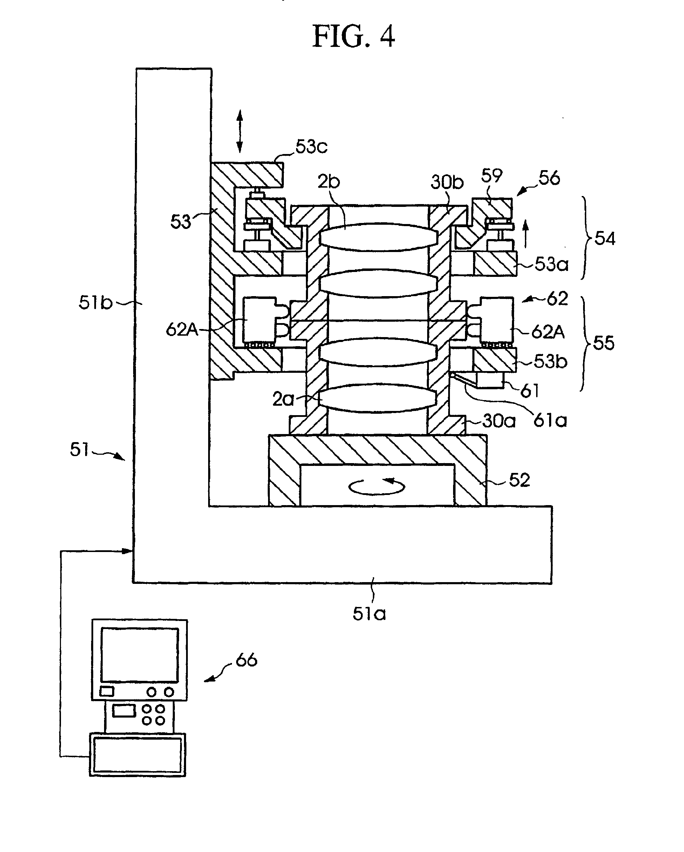

FIG. 4 is a cross-section schematically showing the configuration of the assembly apparatus used at the time of manufacturing the projection optical system according to one embodiment of the present invention. As shown in FIG. 4, the assembly apparatus comprises; a frame 51 having a surface plate portion 5 1a and a pillar portion 51b standing upright from the surface plate portion 51 a, a turntable 52 rotatably provided on the board portion 51a of the frame 51, which uses an air spindle having high rotational accuracy, and a vertically movable stage 53 which is provided on the pillar portion 51b of the frame 51 so as to be able to move vertically. The turntable 52 uses an AC servo motor (not shown) as a drive unit. The vertically movable stage 53 comprises a ball screw for guiding straight advancement of a rolling bearing and driving the rolling bearing, an AC servo motor having an encoder, and an electromagnetic brake for control (neither of these is not shown). The detection of the vertical position of the vertically movable stage 53 is performed by the encoder.

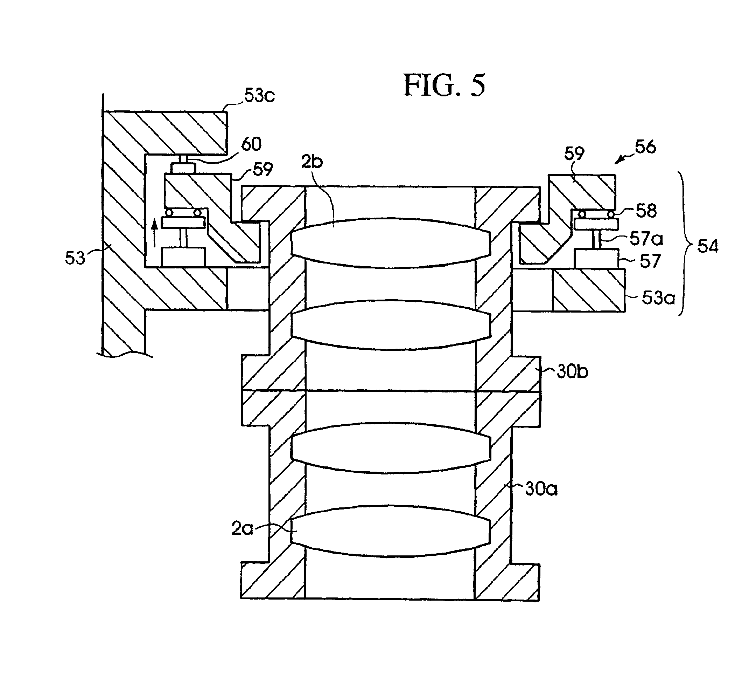

On the vertically movable stage 53 are provided a load reduction section 54 arranged above the turntable 52, and an eccentricity adjusting section 55 arranged below the load reduction section 54. As shown in FIG. 5, the load reduction section 54 comprises an upper annular base 53a arranged above the turntable 52 from the vertically movable stage 53, and a load reduction mechanism 56 arranged above the upper annular base 53a for reducing the load of the split lens-barrels 30a, 30b to 30e, to be position-adjusted. FIG. 5 is a cross-section of the main part showing the load reduction section 54 of the assembly apparatus. The load reduction mechanism 56 comprises; air cylinders 57 which are provided above the upper annular base 53a and can extend or retract rod portions 57a vertically, a plurality of claw members 59 provided at the upper end of the rod portions 57a movably in a direction of thrust, with a thrust bearing 58 placed therebetween, and a load cell 60 provided above the claw member 59 for measuring and controlling the pressure of the air cylinders 57.

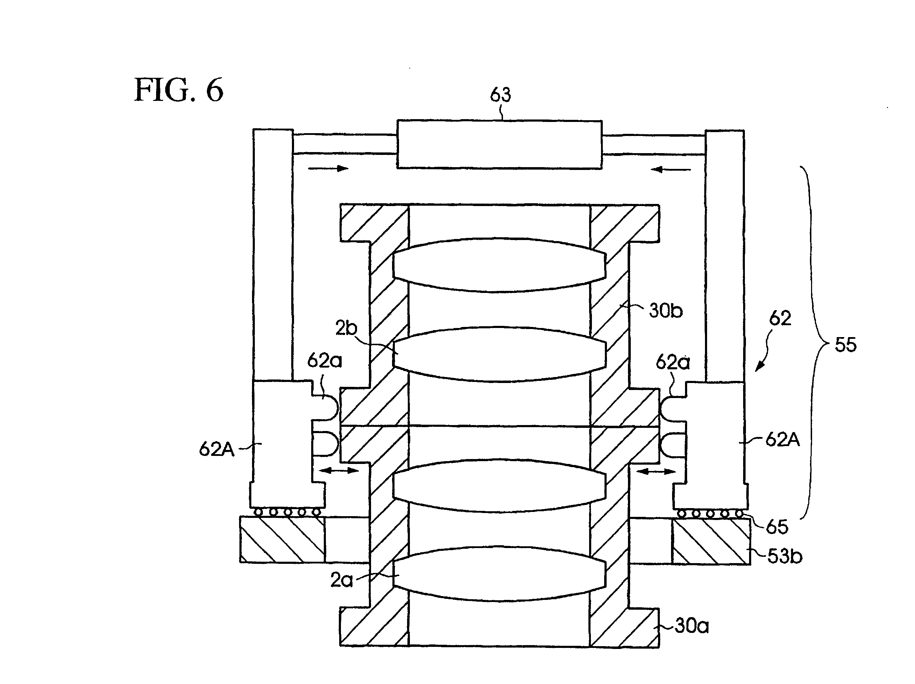

The claw member 59 is formed in an L shape in cross-section, so that the tip thereof can be hooked on to upper flange portions of the split lens-barrels 30a, 30b to 30e arranged inside. The load cell 60 is arranged such that when the claw member 59 is pushed up by the air cylinders 57, the load cell 60 abuts against the lower part of a horizontal protrusion 53c provided on the vertically movable stage 53. The eccentricity adjusting section 55 comprises; as shown in FIG. 4 and FIG. 6, a lower annular base 53b arranged below the upper annular base 53a from the vertically movable stage 53, a contact type electric micrometer (position measuring mechanism, displacement meter) 61 arranged on the lower annular base 53b for detecting the horizontal position (in a direction intersecting the optical axis)

of the split lens-barrel 30a arranged inside, and an eccentricity adjusting mechanism 62 arranged above the lower annular base 53b for adjusting the eccentricity of the split lens-barrel 30a arranged inside thereof. FIG. 6 is a cross-section of the main part showing the eccentricity adjusting section 55 of the assembly apparatus. The contact type electric micrometer 61 is for measuring a deflection (deviation of the optical axis), by bringing the tip of a contact end 61a into contact with a standard diameter portion on the outer circumference of the split lens-barrel 30a. A laser displacement meter or a capacitance type displacement meter may be used instead of the contact type electric micrometer 61. The contact type electric micrometer 61 may be provided on the upper annular base 53a.

As shown in FIG. 6, the eccentricity adjusting mechanism 62 is supported on the lower annular base 53b through an LM guide (Linear Motion) guide (linear guide) 65, and comprises two pairs of chucks 62A which can advance or retreat along an radial direction. These pairs of chucks 62A are arranged such that the advancing and retreating directions thereof are orthogonal to each other, so that the inner split lens-barrel 30a can be placed therebetween with these on the back and front or left and right. Driving of the chucks 62A is performed by an air cylinder 63 for chucks which connects a pair of chucks 62A at the upper part thereof, so that the lower parts of the split lens-barrels 30a, 30b to 30e are placed between the ends of a pair of support protrusions 62a protruding radially inwards of the respective chucks 62A. The respective chucks 62A and the air cylinder 63 for the chucks are arranged so that these do not interfere with the upper annular base 53a or the like. The respective chucks 62A are provided with a linear actuator (positioning mechanism) which is arranged below the support protrusions 62a and can advance or retreat inwards along the radial direction.

Reference symbol 66 denotes a computer which outputs assembly instructions to the assembly apparatus described above. To the computer 66 are input beforehand design data for the projection optical system PL to be assembled, and measurement data such as the refractive index distribution, plane shape and thickness of the respective lens elements 2, and the computer 66 obtains the optical characteristics of the projection optical system PL by simulation, based on these data. The computer 66 then outputs to the assembly apparatus the assembly information for instructing the built-in position and the built-in angle (rotational position of the lens elements 2 about the optical axis) of the respective lens elements 2 in the split lens-barrels 30a to 30e, and the spaces between the split lens-barrels 30a to 30e, by which the optical characteristics become best, based on the results obtained by simulation.

The configuration of the assembly apparatus has been described above. Next is a description of an outline of the assembly process of the split lens-barrels 30a, 30b to 30e. At first, the split lens-barrel 30a located at the bottom of the projection optical system PL is placed on the turntable 52. After placement, the vertically movable stage 53 is shifted to a position where the contact end 61a of the contact type electric micrometer 61 abuts against the standard diameter portion of the split lens-barrel 30a (the claw member 59 is withdrawn beforehand radially outwards). The deflection (misregistration and optical axis deviation) of the split lens-barrel 30a with respect to the turntable 52 is measured by the contact type electric micrometer 61, by rotating the turntable 52 in this state. Thereafter, the vertically movable stage 53 is lowered, and the chucks 62A are shifted so as to be close to each other by the air cylinder 63 for the chucks, so that the outside of the lower flange portion of the split lens-barrel 30a is placed between the chucks 62A. At this time, the linear actuator faces the outer circumference of the turntable 52.

Moreover, the claw member 59 is moved radially inwards and hooked on to the upper flange portion of the split lens-barrel 30a. The air cylinders 57 are driven in this state to press the split lens-barrel 30a upwards (in a direction away from the turntable 52) through the claw member 59 to apply pressure, so that the load of the split lens-barrel 30a applied to the turntable 52 is reduced, and the frictional force between these is reduced. At this time, the load cell 60 abuts against the lower part of the horizontal protrusion 53c to measure the pressure of the air cylinders 57, so that the pressures of the respective air cylinders 57 are adjusted by this measurement to have the same value. In this state, the ends of the respective linear actuators are made to abut against the outer circumference of the turntable 52 and the respective linear actuators are extended or retracted based on the measured deflection, to move the split lens-barrel 30a with respect to the turntable 52 relatively in the horizontal direction (in a direction intersecting the optical axis of the split lens-barrel 30a), to thereby perform eccentricity adjustment (correction of deviation of the optical axis). After the eccentricity adjustment, pressurization by the air cylinders 57 is released, and the space between the chucks 62A is expanded by the air cylinders 63 for the chucks, to thereby release the support of the split lens-barrel 30a.

The second split lens-barrel 30b is then placed on the split lens-barrel 30a, and the deflection measurement and eccentricity adjustment are carried out in the same manner as for the split lens-barrel 30a. In other words, the vertically movable stage 53 is shifted to the position where the contact end 61a of the contact type electric micrometer 61 abuts against the outer circumference of the split lens-barrel 30b. The deflection (misregistration and deviation of the optical axis) of the split lens-barrel 30b with respect to the turntable 52 and the split lens-barrel 30a is measured by the contact type electric micrometer 61, by rotating the turntable 52 in this state. Thereafter, the vertically movable stage 53 is lowered, and the chucks 62A are shifted so as to be close to each other by the air cylinder 63 for the chucks, so that the outside of the lower flange portion of the split lens-barrel 30b is placed between the chucks 62A. At this time, the linear actuator faces the outside of the upper flange of the split lens-barrel 30a. Moreover, the claw member 59 is moved radially inwards and hooked on to the upper flange portion of the split lens-barrel 30b. The air cylinder 57 is driven in this state to press the split lens-barrel 30b upwards (in a direction away from the split lens-barrel 30a) through the claw member 59 to apply pressure, so that the load of the split lens-barrel 30b applied to the split lens-barrel 30a is reduced, and the frictional force between these is reduced. (FIG. 4)

In this state, the ends of the respective linear actuators are made to abut against the outer circumference of the split lens-barrel 30a, and the respective linear actuators are extended or retracted, to thereby move the split lens-barrel 30b with respect to the split lens-barrel 30a relatively in the horizontal direction (in a direction intersecting the optical axis of the split lens-barrel 30b), to thereby perform eccentricity adjustment (correction of deviation of the optical axis). After the eccentricity adjustment, pressurization by the air cylinders 57 is released, and the split lens-barrel 30a and the split lens-barrel 30b are bolted and fixed together at the flange portions thereof. Thereafter, the space between the chucks 62A is expanded, to thereby release the support of the split lens-barrel 30b. Thereafter, eccentricity adjustment is performed by a similar process sequentially for the next split lens-barrel 30c up to the uppermost split lens-barrel 30e, and the split lens-barrels are fixed and assembled together, thereby producing the projection optical system PL.

[Aberration Measuring Apparatus Using the Phase Restoration Method (aberration measuring apparatus)]

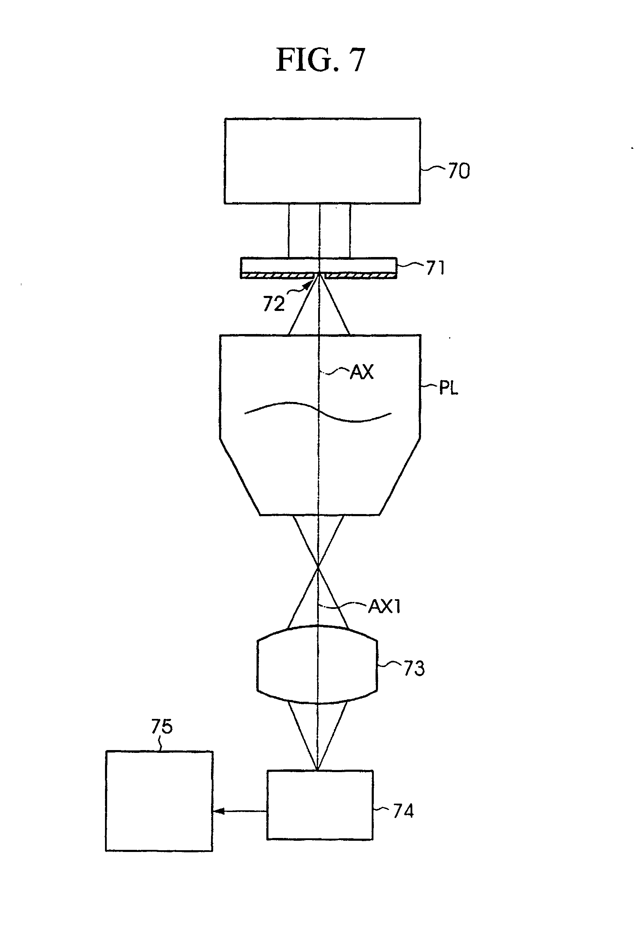

FIG. 7 shows a schematic configuration of the aberration measuring apparatus using the phase restoration method (aberration measuring apparatus). As shown in FIG. 7, the aberration measuring apparatus comprises; an illumination light source 70 for emitting illumination light having a wavelength suitable for the projection optical system PL (for example, illumination light having a central wavelength used at the time of designing the projection optical system PL, narrow wavelength width and high coherency), a pattern plate 71 having a pinhole 72 formed therein, an object lens system 73 in which a front focal position is arranged at an imaging position of the projection optical system PL, an image pickup device 74 such as a CCD (Charge Coupled Device) for imaging the light condensed by the object lens system 73, and a processing section 75 which performs predetermined arithmetic processing based on the phase restoration method, based on a signal intensity distribution of an image pickup signal output from the image pickup device 74. As described above, the aberration measuring apparatus using the phase restoration method (aberration measuring apparatus) has such advantages that it has a simple apparatus configuration and is economical, and the residual aberration of the projection optical system PL can be easily determined.

When the residual aberration of the projection optical system PL is measured by using the aberration measuring apparatus having the above described configuration, at first, as shown in FIG. 7, the pattern forming plane of the pattern plate 71 is positioned on the object plane of the projection optical system PL, and the front focal position of the object lens system 73 is positioned on the imaging position (image plane) of the projection optical system PL. Thereafter, the pinhole 72 formed in the pattern plate 71 is illuminated by the illumination light emitted from the illumination light source 70, to thereby generate an ideal spherical wave. When this ideal spherical wave passes through the projection optical system PL, the ideal spherical wavefront shape changes due to the influence of the aberration remaining in the projection optical system PL. The intensity distribution of the image pickup signal obtained by condensing the light having passed through the projection optical system PL by the object optical system 73 and forming the image thereof by the image pickup device 74 changes corresponding to the residual aberration of the projection optical system PL. Therefore, the residual aberration of the projection optical system PL can be obtained by using an image signal including the information relating to the residual aberration of the projection optical system PL to perform predetermined arithmetic processing based on the phase restoration method. Refer to US Patent No. 4,309,602 for details of the phase restoration method.

[Wavefront Aberration Measuring Apparatus]

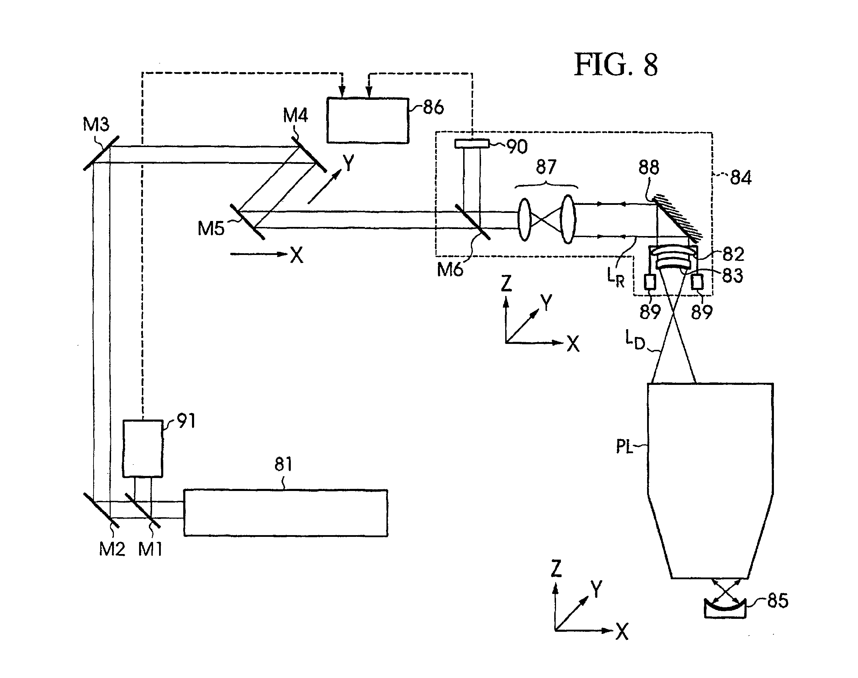

FIG. 8 is a diagram showing a schematic configuration of the wavefront aberration measuring apparatus. The wavefront aberration measuring apparatus shown in FIG. 8 is a wavefront aberration measuring apparatus used at the time of measuring the wavefront aberration of the projection optical system PL suitable for the wavelength of light emitted from the KrF excimer laser (248 nm). The wavefront aberration measuring apparatus shown in FIG. 8 comprises; an Ar ion laser oscillator 81 for emitting an Ar ion laser beam, a wavefront interferometer section 84 having a Fizeau lens 82, mirrors M2 to M5 which guide the Ar ion laser beam to the wavefront interferometer section 84, piezo elements 89 which minutely changes the interference fringe, an image pickup device 90 such as a camera, and a processing apparatus 86 which performs arithmetic processing for the wavefront aberration or the like of the projection optical system PL. In the example shown in FIG. 8, the wavefront interferometer section 84 comprises a Fizeau interferometer.

For the Ar ion laser oscillator 81, a second harmonic oscillator which emits second harmonics of the Ar ion laser beam (a laser beam having a wavelength of 248.25 nm, which is twice the harmonics of the Ar ion laser beam having a wavelength of 496.5 nm) is used. A half mirror M1 is provided between the Ar ion laser oscillator 81 and the mirror M2. This construction is such that the second harmonics of the Ar ion laser beam emitted from the Ar ion laser oscillator 81 (hereinafter simply referred to as a laser beam) passes through the half mirror M1, is sequentially reflected by the mirror M2, mirror M3, mirror M4 and mirror M5, and enters into the half mirror M6 in the wavefront interferometer section 84. The wavefront interferometer section 84 is constructed such that the laser beam having passed through the half mirror M6 is expanded by a beam expander 87, is reflected perpendicularly downwards by a reflection mirror 88, and is made to enter into a Fizeau plane (reference plane) 83, being the final sphere of the Fizeau lens 82, and the projection optical system PL, and the reference light $L_R$ reflected by the Fizeau plane 83, and the light to be detected $L_D$ which has passed through the Fizeau plane 83 and the projection optical system PL and has been reflected by the reflecting sphere 85 and has passed again through the projection optical system PL are combined to thereby generate an interference fringe. The piezo elements 89 are provided for minutely displacing the Fizeau lens 82 in the direction of the optical axis (in the Z-axis direction) to thereby minutely change the interference fringe generated by the wavefront interferometer section 84.

The wavefront interferometer section 84 including the Fizeau lens 82 is placed on a three-axis stage movable in the directions of X-axis, Y-axis and Z-axis. On the other hand, the reflecting sphere 85 is placed on another three-axis stage separate from the Fizeau lens 82. Moreover, there is provided a length measuring interferometer (not shown) which measures the focal position of the Fizeau lens 82 and the focal position (center of curvature) of the reflecting sphere 85. The mirror M5 is constructed so as not to be movable in the X-axis direction, but to move only in the Y-axis direction together with the wavefront interferometer section 84. As a result, even if the wavefront interferometer section 84 and the reflecting sphere 85 move in the directions of the X-axis and Y-axis, the laser beam emitted from the Ar ion laser oscillator 81 can be made to enter into the half mirror M6 in the wavefront interferometer section 84 at all times. A wavelength monitor 91 which measures the fundamental wave of the Ar ion laser beam emitted from the Ar ion laser oscillator 81 or the emission wavelength of the second harmonics is provided in the reflecting optical path of the half mirror M1. The processing apparatus 86 is constructed so as to correct the fluctuation in the emission wavelength measured by the wavelength monitor 91.

In the above configuration, the laser beam emitted from the Ar ion laser oscillator 81 passes through the half mirror M1, and after being reflected by the mirror M2, mirror M3, mirror M4 and mirror M5 respectively, enters into the half mirror M6 in the wavefront interferometer section 84. The laser beam having passed through the half mirror M6 is expanded by the beam expander 87, and reflected by the reflecting mirror 88. The reflected light enters into the Fizeau lens 82 and the projection optical system PL. The reference light $L_R$ reflected by the Fizeau plane 83, and the light to be detected $L_D$ which has passed through the Fizeau plane 83 and the projection optical system PL and has been reflected by the reflecting sphere 85 and has passed again through the projection optical system PL are combined by the reflecting mirror 88, to thereby generate an interference fringe. The interference fringe enters into the image pickup device 90 through the beam expander 87 and the half mirror M6, and the image is formed by the image pickup device 90. The image pickup device 90 outputs a signal relating to the image information of the incident interference fringe to the processing unit 86. While the piezo elements 89 minutely displace the Fizeau lens 82 in the direction of the optical axis (in the Z-axis direction) to minutely change the interference fringe, the interference fringe is formed by the image pickup device 90. Thereby, the processing apparatus 86 obtains the wavefront aberration of the projection optical system PL by performing arithmetic processing, based on the signal relating to the image information of the interference fringe output from the image pickup device 90. The result of the arithmetic processing can be displayed on a display device (not shown) or can be output by a printer (not shown).

The wavefront aberration measuring apparatus used at the time of measuring the wavefront aberration of the projection optical system PL suitable for the wavelength of light emitted from the KrF excimer laser (248 nm) has been described above. For details of this wavefront aberration measuring apparatus, refer for example to US Patent No. 5,898,501. Moreover, refer to Japanese Unexamined Patent Application, First Publication No. 2000-97616 for the details of a wavefront aberration measuring apparatus for measuring the wavefront aberration of the projection optical system PL suitable for the wavelength of light emitted from the ArF excimer laser (193 nm), and refer for example to US Patent No. 5,898,501 for the details of a wavefront aberration measuring apparatus for measuring the wavefront aberration of the projection optical system PL suitable for i-line (365 nm) emitted from an extra-high pressure mercury lamp or the like. The disclosure in US Patent No. 5,898,501 is hereby incorporated by reference.

[Expression Method for Wavefront Aberration by Zernike Polynomial]

In this embodiment, the wavefront aberration is expressed by a Zernike polynomial, in order to facilitate the handling of the wavefront aberration measured by using the aberration measuring apparatus shown in FIG. 7 or the wavefront aberration measuring apparatus shown in FIG. 8. Therefore, basic matters concerning the expression of the wavefront aberration and respective components by the Zernike polynomial will be described below. In the expression by the Zernike polynomial, the polar coordinates are used for a coordinate system, and the Zernike's cylinder function (predetermined function) is used for an orthogonal function system.

At first, the polar coordinates are determined on the emission pupil plane, and the obtained wavefront aberration W is expressed as W ($\rho$, $\theta$). Here, $\rho$ is a standardized radius of a pupil in which the radius of the emission pupil is standardized to 1, and $\theta$ is a radial angle of the polar coordinates. The wavelength W ($\rho$, $\theta$) is developed, using the Zernike's cylinder function system Zn ($\rho$, $\theta$), as shown in the following expression (1):

$$W (\rho, \theta) = \Sigma CnZn (\rho, \theta)$$
$$= C1 \cdot Z1 (\rho, \theta) + C2 \cdot Z2 (\rho, \theta) \cdots + Cn \cdot Zn (\rho, \theta) \ldots\ldots (1)$$

Here, Cn is an expansion coefficient (Zernike coefficient). Of the Zernike's cylinder function system Zn ($\rho$, $\theta$), cylinder function systems Z1 to Z36 according to the first term to the thirty sixth term are as shown below:

n : Zn ($\rho$, $\theta$)
1 : 1
2 : $\rho \cos \theta$
3 : $\rho \sin \theta$
4 : $2\rho2 - 1$
5 : $\rho2 \cos2 \theta$
6 : $\rho2 \sin2 \theta$
7 : $(3 \rho2 - 2) \rho \cos \theta$
8 : $(3 \rho2 - 2) \rho \sin \theta$
9 : $6\rho4 - 6\rho2 + 1$
10 : $\rho3 \cos3 \theta$
$\rho$11 : $\rho3 \sin3 \theta$
12 : $(4 \rho2 - 3) \rho2 \cos2 \theta$
13 : $(4 \rho2 - 3) \rho2 \sin2 \theta$
14 : $(10 \rho4 - 12\rho2+3) \rho \cos \theta$
15 : $(10 \rho4 - 12\rho2 + 3) \rho \sin \theta$
16 : $20\rho6 - 30\rho4 + 12\rho2 -1$
17 : $\rho4 \cos4 \theta$
18 : $\rho4 \sin4 \theta$
19 : $(5 \rho2 - 4) \rho3 \cos3 \theta$
20 : $(5 \rho2 - 4) \rho3 \sin3 \theta$
21 : $(15 \rho4 - 20\rho2 + 6) \rho2 \cos2 \theta$
22 : $(15 \rho4 - 20\rho2 + 6) \rho2 \sin2 \theta$
23 : $(35 \rho6 - 60\rho4 + 30\rho2 - 4) \rho \cos \theta$
24 : $(35 \rho6 - 60\rho4 + 30\rho2 - 4) \rho \sin \theta$
25 : $70\rho8 - 140\rho6 + 90\rho4 - 20\rho2 + 1$
26 : $\rho5 \cos5 \theta$
27 : $\rho5 \sin5 \theta$
28 : $(6 \rho2 - 5) \rho4 \cos4 \theta$
29 : $(6 \rho2-5) \rho4 \sin4 \theta$
30 : $(21 \rho4-30\rho2 + 10) \rho3 \cos3 \theta$
31 : $(21 \rho4-30\rho2+10) \rho3 \sin3 \theta$
32 : $(56 \rho6 - 104\rho4 + 60\rho2 - 10) \rho2 \cos2 \theta$
33 : $(56 \rho6 - 104\rho4+60\rho2- 10) \rho2 \sin2 \theta$
34 : $(126 \rho8 - 280\rho6+ 210\rho4 - 60\rho2 + 5) \rho \cos \theta$
35 : $(126\rho8-280\rho6+210\rho4-60\rho2+5) \rho \sin \theta$
36 : $252\rho10-630\rho8 +560\rho6-210\rho4+30\rho2- 1$.

The evaluation method based on the wavefront aberration W in the related art employs a difference between the maximum and the minimum of the whole components W in the wavefront aberration, or an RMS (root mean square) value as the evaluation index. However, even when the same value is obtained in the evaluation using the P - V value of the whole components W in the wavefront aberration or the RMS value, desired performance may not be achieved depending on the combination of the expansion coefficients C1, C2 etc. in each term. Therefore, in the present invention, the whole components of the wavefront aberration W are taken into consideration.

The wavefront aberration W can be classified into rotationally symmetric components, odd symmetric components and even symmetric components. The rotationally symmetric components are terms which do not include θ, that is, rotationally symmetric components in which a value at a certain coordinate is equal to a value at a coordinate obtained by rotating the coordinate by an optional angle, using the center of the pupil as a center. The odd symmetric components are terms including trigonometric functions obtained by multiplying the radial angle θ by odd numbers, such as sin θ (or cos θ) and sin 3θ (or cos 3θ), that is, are odd symmetric components in which a value at a certain coordinate is equal to a value at a coordinate obtained by rotating the coordinate by one-to-an odd number of 360 degrees, using the center of the pupil as a center. Moreover, the even symmetric components are terms including trigonometric functions obtained by multiplying the radial angle θ by even numbers, such as sin 2θ (or cos 2θ) and sin 4θ (or cos 4θ), that is, are even symmetric components in which a value at a certain coordinate is equal to a value at a coordinate obtained by rotating the coordinate by one-to-an even number of 360 degrees, using the center of the pupil as a center.

In this case, the rotationally symmetric component Wrot, the odd symmetric component Wodd and the even symmetric component Wevn of the wavefront aberration W are expressed by the following expressions (2) to (4), respectively. For simplifying the expression, it is assumed as a rule that the n-th term is expressed by the expansion coefficient Cn in the n-th term. In other words, in the expression of the following expressions (2) to (4) and respective components, Cn means Cn Zn.

$$Wrot\ (\rho, \theta) = C4 + C16 + C25 + C36 \qquad (2)$$

$$Wodd\ (\rho, \theta) = C7 + C8 + C10 + C11 + C14 + C15$$
$$+ C19 + C20 + C23 + C24 + C26$$
$$+ C27 + C30 + C31 + C34 + C35 \qquad (3)$$

$$Wevn\ (\rho, \theta) = C5 + C6 + C12 + C13 + C17 + C18$$
$$+ C21 + C22 + C28 + C29 + C32$$
$$+ C33 \qquad (4)$$

[Production Method for Projection Optical System]

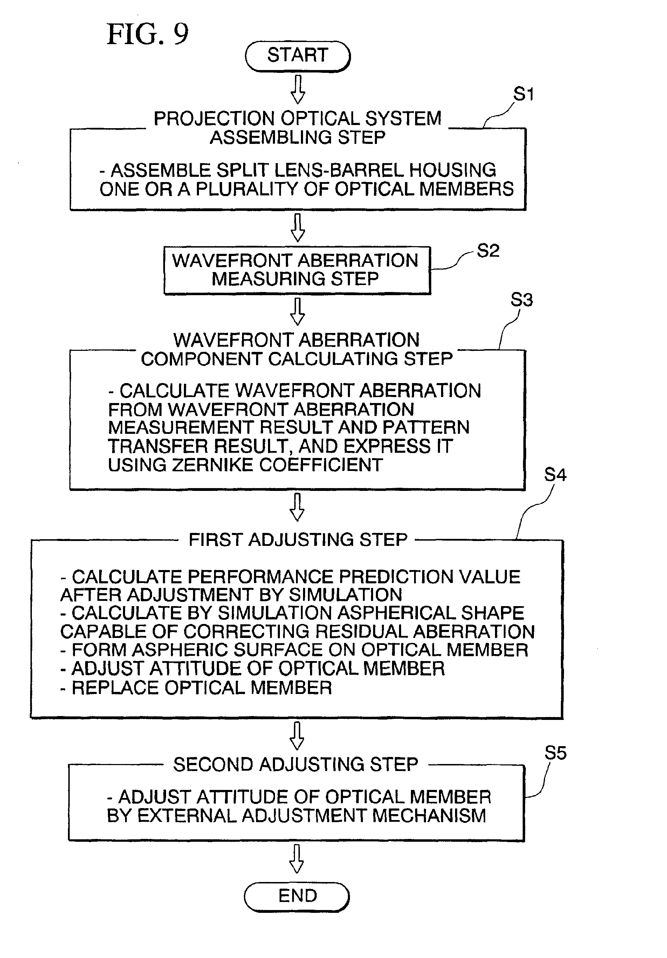

The production method for a projection optical system according to one embodiment of the present invention will be described below. Before describing the details of the production method for a projection optical system according to the one embodiment, the outline thereof is briefly described. FIG. 9 is a flowchart showing the outline of the production method for a projection optical system according to the one embodiment. As shown in FIG. 9, the production method for a projection optical system according to this embodiment has an assembly step S1 for a projection optical system, a wavefront aberration measuring step S2, a wavefront aberration component calculating step S3, a first adjusting step S4 and a second adjusting step S5.

In the assembly step S1 of the projection optical system, one or a plurality of optical members are installed inside the split lens-barrels 30a to 30e to assemble the respective split lens-barrels 30a to 30e, and the assembled split lens-barrels 30a to 30e are assembled by using the assembly apparatus (see FIG. 4 to FIG. 6), to thereby obtain the projection optical system PL. In the wavefront aberration measuring step S2, the aberration remaining in the assembled projection optical system PL is measured by using the aberration measuring apparatus shown in FIG. 7 or the wavefront aberration measuring apparatus shown in FIG. 8 is measured. In the wavefront aberration component calculating step S3, the above described Zernike coefficient is obtained based on the measurement result in the wavefront aberration measuring step S2, to thereby express the wavefront aberration remaining in the projection optical system PL with the Zernike polynomial. Moreover, an image of a predetermined pattern (for example, ideal grating) is transferred to the wafer W through the assembled projection optical system PL, and distortion (distortion aberration) of the projection optical system is obtained from the transfer result.

This is because values different from the residual aberration in the actual projection optical system PL are measured as the values of the second term and the third term according to the expansion coefficients C2 and C3 in the measurement results in the wavefront aberration measuring step S2, corresponding to the relative misregistration between the projection optical system PL and the aberration measuring apparatus or the wavefront aberration measuring apparatus. Therefore, the values of the second term and the third term according to the expansion coefficients C2 and C3 are obtained from the result of actually transferring the pattern, and from the wavefront aberration expressed by the expansion coefficient C4 and thereafter. Thereby accurate wavefront aberration is expressed by the Zernike polynomial. The expansion coefficients C2 and C3 relate to the tilt component as described above, and indicate how much the wavefront tilts from the plane orthogonal to the optical axis of the projection optical system PL. Therefore, this tilt component as a result, greatly affects the distortion. Hence an accurate value is obtained by actually transferring a predetermined pattern.

In the first adjusting step S4, the projection optical system PL is adjusted based on the wavefront aberration indicated by the Zernike coefficient obtained in the wavefront aberration component calculating step S3. The adjustment is basically performed by adjusting the attitude of the optical members built into the projection optical system PL (including the position of the optical members in the direction of the optical axis AX, the position (eccentricity) thereof in a plane orthogonal to the optical axis AX, the rotational displacement thereof about an axis orthogonal to the optical axis AX, and the rotational displacement thereof about the optical axis AX). However, the projection optical system PL is adjusted here by obtaining a performance predicted value after adjustment of the projection optical system PL by simulation in advance, taking into consideration the arrangement of the optical members in the projection optical system from the design of the projection optical system PL. When it is judged by the simulation that the residual aberration cannot be corrected to less than the predetermined value by the attitude adjustment of the optical member, the optical member in the projection optical system PL is replaced, and re-assembled. Moreover, an aspherical shape that can correct the residual aberration in the projection optical system PL is calculated by simulation, and an aspheric surface is formed in the predetermined optical member in the projection optical system PL, according to the simulation result. In the first adjusting step, adjustment is carried out until the performance predicted value of the projection optical system PL after the adjustment in the second adjusting step reaches the predetermined performance.

In the second adjusting step S5, the attitude of the optical member provided in the projection optical system PL is adjusted from outside, using the external adjustment mechanism (for example, the adjusting members 32a to 32e, and the parallel plate drive 35 shown in FIG. 1) provided in the projection optical system PL. As required, at least one of the optical members in the projection optical system PL adjacent to the wafer W (for example, the glass plate 8 or the like in FIG. 1) and an optical member (not shown) adjacent to the reticle R is replaced. Moreover, if necessary, adjustment for changing the wavelength suitable for the projection optical system PL is carried out by changing the wavelength of the illumination light. In the second adjusting step, such adjustment is carried out until the performance of the projection optical system reaches the final performance.

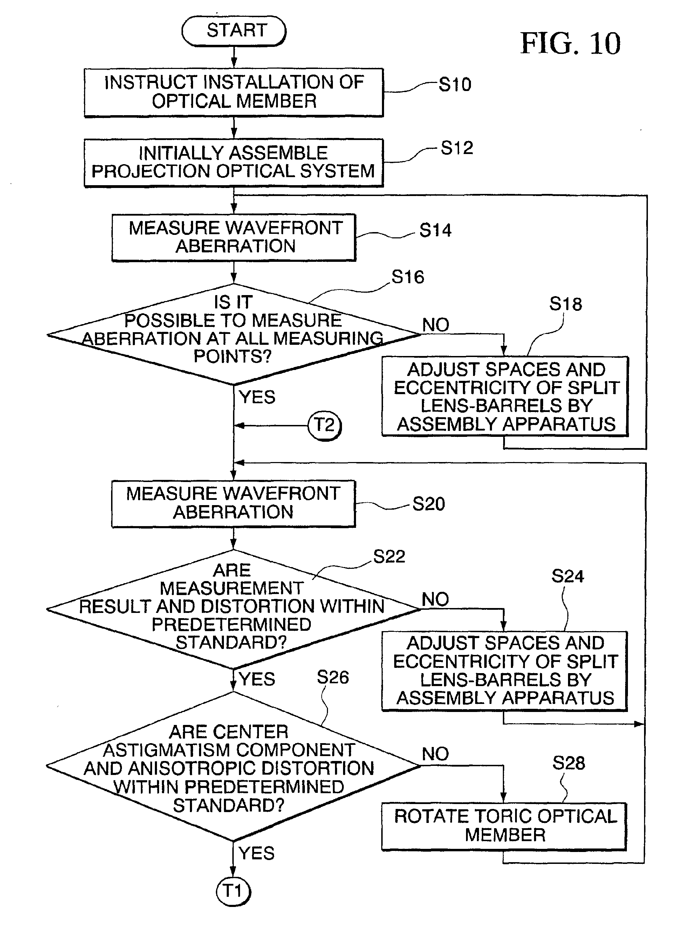

The outline of the production method for a projection optical system PL according to the one embodiment of the present invention has been described. Next is a description of the detailed flow thereof. Flowcharts showing detailed flow of the production method for a projection optical system according to the one embodiment of the present invention are shown in FIG. 10 to FIG. 12. In flowcharts, the judging step is generally illustrated by a diamond frame, but for the convenience sake, in FIG. 10 to FIG. 12, the judging step (for example, steps S16, S22 and S26 in FIG. 10) is expressed as illustrated.

In order to produce the projection optical system PL, at first, the computer 66 outputs an installation instruction to the assembly apparatus shown in FIG. 4 (step S10), and the assembly apparatus installs one or a plurality of optical members such as a lens element 2 into the split lens-barrels 30a to 30e to assemble the split lens-barrels 30a to 30e, respectively, based on the installation instruction from the computer 66, and also assembles the assembled the split lens-barrels 30a to 30e, to thereby obtain the projection optical system PL (step S12). Steps S10 and S12 in FIG. 10 correspond to the assembly step S1 in FIG. 9.

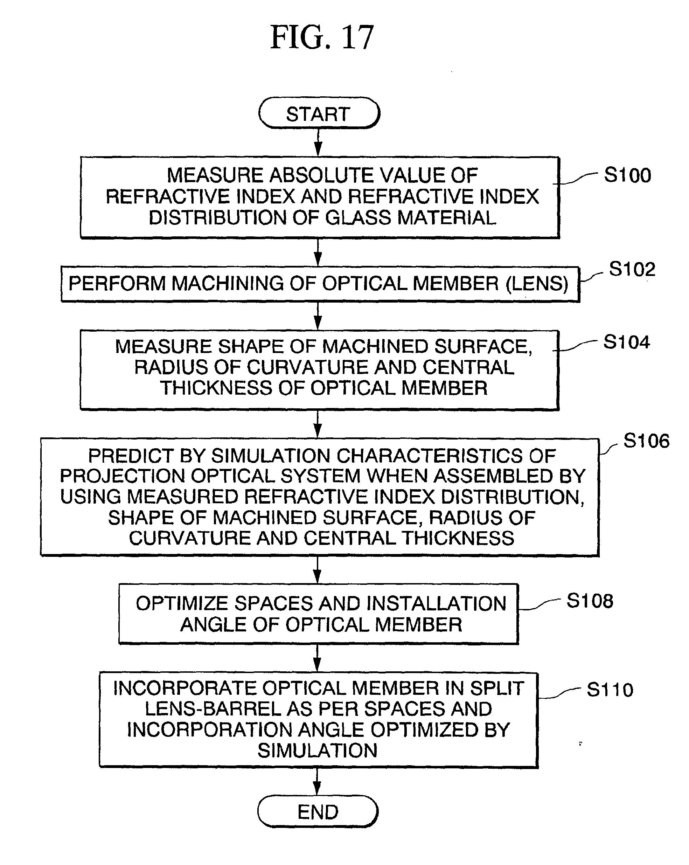

Here, heterogeneity in refractive index distribution and production errors in machined surfaces occur in the optical members installed in the split lens-barrels 30a to 30e. Therefore, it is desired for improving the production efficiency to install the optical members in the split lens-barrels 30a to 30e, taking these factors into consideration beforehand, such that the optical characteristics of the projection optical system PL become best (the wavefront aberration becomes minimum). Details of a series of steps performed from the production of the optical members installed in the split lens-barrels 30a to 30e until the optical members are installed in the split lens-barrels will be described below. FIG. 17 is a flowchart showing the details of the series of steps carried out from the production of the optical members installed inside the split lens-barrels 30a to 30e until the optical members are installed into the split lens-barrels.

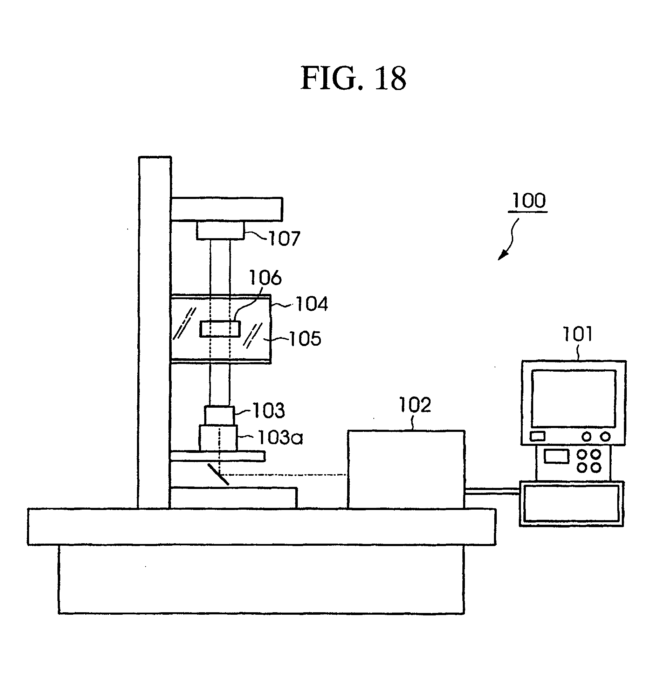

In FIG. 17, at first a block glass material (blank) for forming the respective optical members is produced, and then an absolute value of refractive index and the refractive index distribution of the produced block glass material are measured, using the interferometer apparatus shown in FIG. 18 (step S100). FIG. 18 is a diagram showing the configuration of the interferometer apparatus for measuring the absolute value of the refractive index and the refractive index distribution of the block glass material. In the interferometer apparatus 100 shown in FIG. 18, an outgoing beam from an interferometer unit 102 controlled by a control system 101 enters into a Fizeau flat (Fizeau plane) 103 supported on a Fizeau stage 103a. The beam reflected by the Fizeau flat 103 returns to the interferometer unit 102 as a reference beam.

On the other hand, the beam having passed through the Fizeau flat 103 enters into an object to be detected in a sample case 104, as a measuring beam. Oil 105 is filled in the sample case 104, and the above described block glass material 106, being the object to be detected, is placed at a predetermined position in the sample case 104. The beam having passed through the block glass material 106 is reflected by the reflecting plane 107, and returns to the interferometer unit 102 through the block glass material 106 and the Fizeau flat 103. The wavefront aberration due to the refractive index distribution of the respective block glass materials 106, and consequently, the wavefront aberration due to the refractive index distribution of the respective optical members are measured, based on the phase shift between the reference beam returned to the interferometer unit 102 and the measuring beam. Refer for example to US Patent No. 6,025,955 for details relating to the measurement of the homogeneity in the refractive index by using the interferometer. The disclosure in US Patent No. 6,025,955 is hereby incorporated herein by reference. The measured absolute value of the refractive index and refractive index distribution of the block glass material 106 are input to the computer 66 shown in FIG. 4 and stored as a database. A standard is preset for the refractive index distribution of the block glass material 106, and a block glass material 106 having a refractive index distribution outside the standard, as a result of the measurement, is not used.

When the measurement of the absolute value of the refractive index and the refractive index distribution of the block glass material 106 is finished, grinding and polishing are performed with respect to the measured block glass material 106, to thereby implement the process for producing the optical members to be arranged in the projection optical system PL as per the design (step S102). The design data for the projection optical system PL is input to the computer 66 beforehand. Next, the shape of the machined surface, the radius of curvature and the central thickness of the machined optical member are measured (step S104). The shape of the machined surface of the optical member is measured by measuring a deviation on the machined surface with respect to an ideal sphere (best fit sphere). The shape of the machined surface of the optical member is measured by using an interferometer to which is applied for example, a Twyman and Green interferometer or a Fizeau interferometer. Refer for example to US Patent No. 5,561,525 or US Patent No. 5,563,706 for the specific configuration of this interferometer. The disclosure in US Patent No. 5,561,525 and the disclosure in US Patent No. 5,563,706 are hereby incorporated herein by reference.

The radius of curvature of the optical member is measured by using a Newton gauge or a laser interferometer. The method of performing measurement by using the Newton gauge is such that an optical member is placed on a test plate glass having an aspheric surface formed with high accuracy, and a Newton's ring obtained when a beam emitted from a light source having a certain wavelength, for example, a beam emitted from a mercury lamp or a sodium lamp is irradiated from the optical member side is observed to obtain the radius of curvature of the optical member. Refer for example to Japanese Unexamined Patent Application, First Publication Nos. Hei 5-272944, Hei 6-129836, and Hei 6-174451 for the details of the method for measuring the radius of curvature of the optical member using the Newton gauge. Moreover, refer to Japanese Unexamined Patent Application, First Publication Nos. Hei 5-340734, Hei 5-340735 and Hei 5-346315 for the details of the method of measuring the radius of curvature of the optical member, using the laser interferometer.

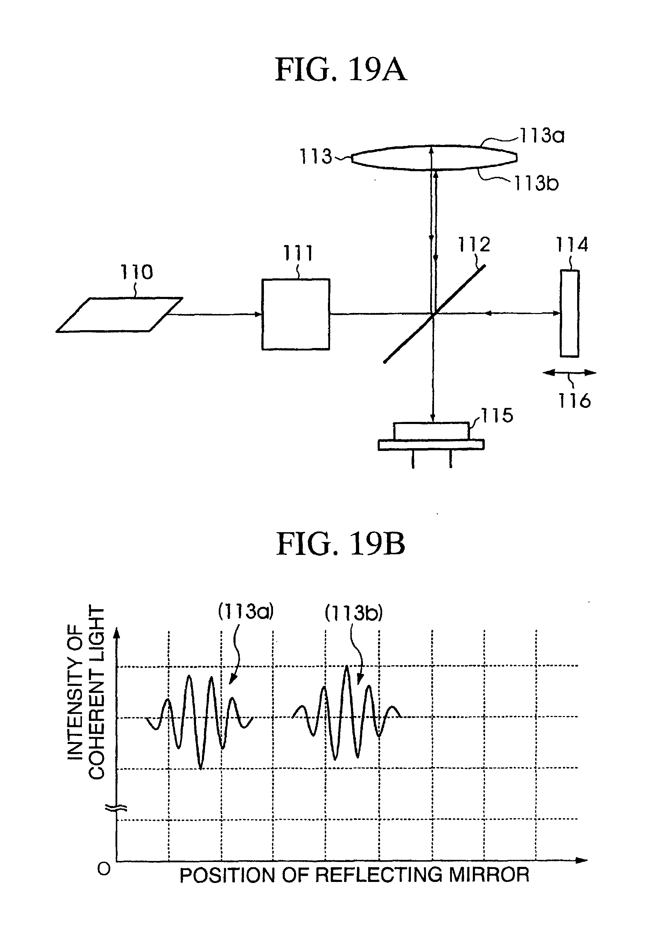

The central thickness of the optical member is measured by using a central thickness measuring apparatus shown in FIG. 19A. FIG. 19A is a schematic block diagram of a central thickness measuring apparatus using a Michelson interferometer. This central thickness measuring apparatus comprises a light source 110 which emits a measuring beam having a predetermined wavelength, an optical system 111, and a half mirror 112. The optical system 111 comprises a pinhole, a collimator lens and the like (not shown), and forms the measuring beam emitted from the light source 110 into a parallel beam of light and shines the beam onto the half mirror 112. The half mirror 112 reflects a part of the incident beam and transmits the rest.

As a result, a part of the beams shone from the light source 110 side is reflected to the optical member 113 side, being an object whose central thickness is to be measured, and the remaining beams are transmitted through to the reflecting mirror 114 side. The surface of the optical member 113 on the half mirror 112 side and the backside of the optical member 113 are reflecting surfaces 113a and 113b, respectively, with respect to the beams reflected toward the optical member 113 side. The reflecting mirror 114 is fitted to the movable stage (not shown), and constructed so as to be able to move together with the movable stage in a direction of an arrow denoted by reference symbol 116 in FIG. 19A, and the reflecting mirror 114 reflects the beams transmitted through the half mirror 112 so as to return to the half mirror 112.

The beam reflected by the optical member 113 transmits through the half mirror 112 and enters into a light-receiving element 115 as the measuring beam. On the other hand, the beam reflected by the reflecting mirror 114 is reflected by the half mirror 112 and reaches the light-receiving element 115 as the reference beam. These measuring beam and reference beam are set so as to interfere with each other on the light-receiving element 106. The light-receiving element 115 photoelectrically converts the coherent light of the measuring beam and the reference beam, and outputs the coherent light to the outside as an interference signal.

FIG. 19B is a diagram showing the relation between the intensity of the coherent light which is shone onto the light-receiving element 115 and the position of the reflecting mirror 114, when a light source having a sufficiently smaller coherent distance than the measured space is used as the light source 110. Here, the optical path length of the optical path, in which the measuring beam is separated by the half mirror 112, reflected by the reflecting surface 113a of the optical member 113 and reaches the half mirror 112 again, is assumed to be A1. Moreover, the optical path length of the optical path, in which the measuring beam is separated by the half mirror 112, reflected by the reflecting surface 113b of the optical member 113 and reaches the half mirror 112 again, is assumed to be A2. Furthermore, the optical path length of the optical path, in which the reference beam is separated by the half mirror 112, reflected by the reflecting mirror 114 and reaches the half mirror 112 again, is assumed to be B.

The measuring beams reflected by the reflecting surfaces 113a and 113b interfere with the reference beam reflected by the reflecting mirror 114, due to the half mirror 112, corresponding to the difference in the optical path length. In other words, the respective measuring beams and the reference beam interfere with each other, when the optical path lengths A1 and A2, and the optical path length B becomes substantially equal, and the coherent light whose intensity changes at this time can be obtained. Therefore, when the optical path length B becomes substantially equal to the optical path length A1 by shifting the position of the reflecting mirror 114, the intensity of the coherent light shone onto the light-receiving element 115 changes like the waveform indicated by reference symbol 113a in FIG. 19B. Moreover, when the optical path length B becomes substantially equal to the optical path length A2, the intensity of the coherent light shone onto the light-receiving element 115 changes like the waveform indicated by reference symbol 113b in FIG. 19B.

In the case where during the period while the measuring beam and the reference beam are separated and combined again by the half mirror 112, the measuring beam and the reference beam enter from, for example, a medium having a low refractive index and are reflected by a border plane between the medium and a medium having a high refractive index, for example, are reflected by the reflecting surface 113a, inversion of phase by 180 degrees, that is a so-called phase jump occurs. In this case, the intensity distribution of the coherent light becomes a state inverted with respect to the center of the amplitude, like the intensity change of the coherent light indicated by reference symbol 113a with respect to the intensity change of the coherent light indicated by reference symbol 113b in FIG. 19B. The central thickness of the optical member 113 is then obtained based on the interference signal output from the light-receiving element 106 corresponding to the intensity distribution of the coherent light and the position of the reflecting mirror 114 set on the movable stage. In order to measure the central thickness of the optical member, a contact type measuring method using a measuring needle may be used, other than the above described measuring method. Normally, an anti-reflection film is formed on the machined optical member, but this anti-reflection film may be formed before or after the measurement described above.

The shape of the machined surface, the radius of curvature and the central thickness of the optical member measured by the measuring method described above are input to the computer 66 shown in FIG. 4, and stored as a database. Subsequently, a prediction process is carried out, in which the characteristics of the projection optical system PL when it is assembled by using the optical members having the measured refractive index distribution, shape of the machined surface, radius of curvature and central thickness, are predicted by simulation by the computer 66 (step S106). Specifically, after the spaces between the optical members included in the projection optical system PL are set as per the design, the characteristics of the projection optical system PL are obtained, taking the above measurement result into account. Here, evaluation of the characteristics of the projection optical system PL is conducted, using the P-V value and the RSM value of the whole components W of the wavefront aberration.

The characteristics of the projection optical system PL when changing the spaces between the optical members virtually assembled by simulation and the rotation angle (installation angle) thereof about the optical axis are obtained by simulation. Since the above described heterogeneity in the refractive index distribution and production error have occurred in the optical member produced in step S102, then even when only the rotation angle (installation angle) about the optical axis of the optical member is changed, the characteristics of the projection optical system PL change. Here, the spaces between the respective optical members and the installation angle are optimized so that the optical characteristics become the best (step S108). When the spaces between the respective optical members and the installation angle are optimized through the above steps, the computer 66 outputs the installation information to the assembly apparatus shown in FIG. 4. On receiving the installation information from the computer 66, the assembly apparatus installs the optical members in the split lens-barrels 30a to 30e as per the optimized spaces between the respective optical members and installation angle included in the installation information, to assemble the respective split lens-barrels 30a to 30e, and assemble the assembled split lens-barrels 30a to 30e, to thereby obtain the projection optical system PL (step S110).

When the projection optical system PL is assembled by the assembly apparatus, the wavefront aberration is measured using the aberration measuring apparatus shown in FIG. 7 (step S14). In order to measure the residual aberration in the projection optical system PL, as shown in FIG. 7, it is necessary to measure the wavefront aberration not only for a case where the pinhole 72 formed in the pattern plate 71 is arranged on the optical axis AX of the projection optical system PL, but also for a state in which the pinhole 72 is arranged at a plurality of measuring points (for example, several tens of points) in a plane orthogonal to the optical axis AX. Therefore, in this step, the wavefront aberration is measured, while moving the position of the pinhole 72 toward the measuring points in the plane orthogonal to the optical axis AX. The configuration may be such that a plurality of pinholes is formed in the pattern plate 71, rather than moving the pattern plate 71, and a member for specifying the illumination area is provided in the illumination light source 70 so as to illuminate one pinhole at a time, to thereby measure the wavefront aberration.

It is then judged whether the wavefront aberration can be measured at all measuring points (step S16). The aberration measuring apparatus shown in FIG. 7 performs predetermined arithmetic processing with respect to the image pickup signal obtained by imaging with the image pickup device 74, based on the phase restoration method, to thereby obtain the residual aberration in the projection optical system PL. With the phase restoration method, however, if the residual aberration in the projection optical system PL is too large, the wavefront cannot be restored. Therefore, in step S16, it is judged whether the wavefront aberration can be measured at all measuring points. If it is judged there is at least one measuring point where the aberration measurement is not possible (the judgment result is "NO"), the assembly apparatus performs space adjustment of the split lens-barrels 30a to 30e and eccentricity adjustment between the split lens-barrels 30a to 30e (step S18), and after the adjustment, control returns to step S14.

On the other hand, in step S16, when it is possible to measure the aberration at all measuring points (the judgment result is "YES"), the aberration measuring apparatus measures the wavefront aberration at all measuring points (step S20). When the measurement is finished, it is judged whether the RMS value of the wavefront aberration and the distortion are within the predetermined standard (step S22). This step is for judging whether the projection optical system PL has been adjusted to a degree capable of performing highly accurate aberration measurement described later. If this judgment result is "NO", space adjustment of the split lens-barrels 30a to 30e and eccentricity adjustment between the split lens-barrels 30a to 30e are conducted (step S24), and after the adjustment, control returns to step S20.

On the other hand, when the judgment result in step S22 is "YES", that is, when it is judged that the projection optical system PL has been adjusted to a degree capable of performing highly accurate aberration measurement described later, it is judged whether the center astigmatism component and the anisotropic distortion are within the predetermined standard (step S26). Here, the center astigmatism component is an astigmatism component occurring at the center of the projection area of the projection optical system PL. The anisotropic distortion stands for an aberration in which the imaging magnification is different in a predetermined meridian direction in the image plane and in a meridian direction orthogonal thereto. When the judgment result in step S22 is "NO", the center astigmatism component is adjusted by rotating the optical member for correcting the center astigmatism component (step S28).

Here, the optical member for correcting the center astigmatism component is an optical member having a toric plane formed thereon, which has a different curvature in the X-axis direction and in the Y-axis direction. As a result, the center astigmatism component can be corrected by rotating the optical member having this toric plane formed thereon.

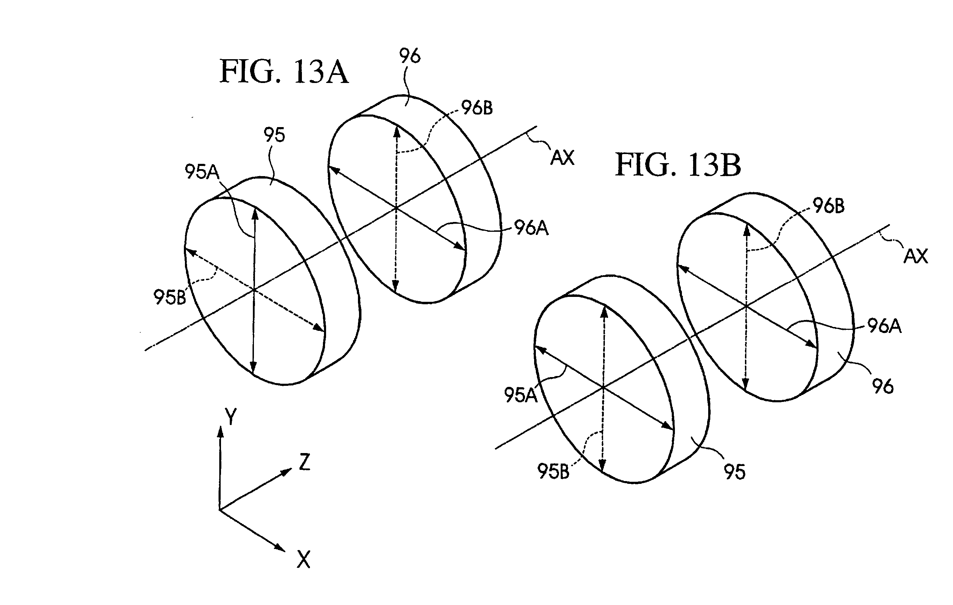

The principle for correcting the center astigmatism component by using the optical member having the toric plane formed thereon will be briefly described below. FIGS. 13A and 13B are diagrams for explaining the principle for correcting the center astigmatism component. In these figures, the optical members 95 and 96 are optical members, being a part of the optical members constituting the projection optical system PL. At least one of these optical members 95 and 96 is provided rotatably about the optical axis AX. The optical members 95 and 96 have, respectively, a direction 95A, 96A in which the radius of curvature is strongest, and a direction 95B, 96B orthogonal to the direction 95A, 96A, in which the radius of curvature is weakest. Here, in the direction 95A, 96A indicated by a solid line, the refracting power of the optical member becomes strongest, and in the direction 95B, 96B indicated by a broken line in the figure, the refracting power of the optical member becomes weakest. In the following description, the direction 95A, 96A in which the radius of curvature (refracting power) becomes strongest is referred to as a strong main meridian, and the direction 95B, 96B in which the radius of curvature (refracting power) becomes weakest is referred to as a weak main meridian.

As shown in FIG. 13A, when the strong main meridians 95A and 96A form 90 degrees with each other in the two optical members 95 and 96, the center astigmatism component and the anisotropic distortion do not occur in the two optical members 95 and 96. Moreover, as shown in FIG. 13B, in the two optical members 95 and 96, when the angle formed between the strong main meridians 95A and 96A is deviated from 90 degrees, the center astigmatism component or the anisotropic distortion on the axis occurs in an amount corresponding to the angle between these.

Therefore, for example, when the optical surfaces of two optical members, of the optical members constituting the projection optical system PL, are formed in a shape having a power different in a predetermined meridian direction and in a direction orthogonal to this meridian direction, and can be rotated relative to each other about the optical axis AX, either one of the center astigmatism component and the anisotropic distortion can be corrected. Moreover, when the optical surfaces of two optical members different from the above two optical members, are formed in a shape having a power different in the predetermined meridian direction and in a direction orthogonal to this meridian direction, and can be rotated relative to each other about the optical axis AX, both of the center astigmatism component and the anisotropic distortion can be corrected. It is preferable to provide the optical surface for adjusting the amount of occurrence of the center astigmatism component in the vicinity of the pupil of the projection optical system PL, and it is preferable to provide the optical surface for adjusting the amount of occurrence of the anisotropic distortion in the vicinity of the object plane or the image plane. Refer for example to US Patent Nos. 5,852,518 and 6,262,793, and Japanese Unexamined Patent Application, First Publication No. 2000-164489 for the details of the method for adjusting the center astigmatism component and the anisotropic distortion. The disclosures in US Patent Nos. 5,852,518 and 6,262,793 are hereby incorporated herein by reference.

Returning to FIG. 10, after the adjustment by rotating the optical member for correcting the center astigmatism component and/or the anisotropic distortion, control returns to step S20, to perform the wavefront aberration measurement again. On the other hand, when the center astigmatism component and the anisotropic distortion are within the predetermined standard (when the judgment result in step S26 is "YES"), control proceeds to step S30. In other words, the steps S14 to S26 above are steps for performing adjustment of the projection optical system PL to a degree capable of performing highly accurate aberration measurement, and when the judgment result in step S26 becomes "YES", it means that the aberration remaining in the projection optical system PL is corrected to such a degree that highly accurate aberration measurement can be performed.

Highly accurate wavefront aberration measurement is then performed (step S30) by using the wavefront aberration measuring apparatus shown in FIG. 8, and an image of a predetermined pattern (for example, an ideal grating) is transferred onto the wafer W through the projection optical system PL (step S32). The Zemike's cylinder function system $Zn$ ($\rho$, $\theta$) is fitted to the measurement result in step S30 to obtain the expansion coefficient $Cn$ (Zernike coefficient) for each term, and the processing for calculating the wavefront aberration component is carried out by the processing apparatus 86 (step S34). When the expansion coefficient $Cn$ is calculated, the wavefront aberration W ($\rho$, $\theta$) can be finally obtained from the above described expression (1), using the expansion coefficient $Cn$ and the Zernike's cylinder function system $Zn$ ($\rho$, $\theta$).

In this embodiment, the values of the second term and the third term according to the expansion coefficients $C2$ and $C3$ in the measurement result by the wavefront aberration measuring step S2 are measured in values different from the actual aberration remaining in the projection optical system, corresponding to the relative misregistration between the projection optical system PL and the aberration measuring apparatus or the wavefront aberration measuring apparatus. Therefore, the distortion values relating to the second term and the third term according to the expansion coefficients $C2$ and $C3$ are controlled separately from the values of respective components of the wavefront aberration (the expansion coefficient $C4$ and thereafter). In this case, the values of the second term and the third term according to the expansion coefficients $C2$ and $C3$ are determined from the result of transferring the predetermined pattern in step S32 and the wavefront aberration determined by the expansion coefficients of the expansion coefficient $C4$ and thereafter calculated in step S34, and the accurate wavefront aberration is expressed by the Zernike polynomial, and this wavefront aberration component (of the expansion coefficient $C2$ and thereafter) may be used.

The wavefront aberration (or respective components of the wavefront aberration) and the distortion having been adjusted by using the external adjustment mechanism (adjusting members 32a to 32e, the parallel plate drive 35, and the glass plate 8 shown in FIG. 1), in the case where the projection optical system PL has the calculated values of respective components of the wavefront aberration and the measured value of distortion, are predicted by simulation, using the calculated values of respective components of the wavefront aberration and the measured value of distortion. Specifically, the calculated values of respective components of the wavefront aberration and the measured value of distortion are designated as a starting point, and optimized as the parameters of the external adjustment mechanism (the shift quantity of the adjusting members 32a to 32e, the driving quantity of the parallel plate drive 35, and the shape and thickness of the glass plate 8), to thereby obtain the aberration (wavefront aberration and distortion) of the optimized projection optical system PL.

It is then judged whether the predicted wavefront aberration and distortion are within the predetermined standard, by the predetermined apparatus 86 (step S38). The predetermined standard includes, for example, the standard for each of the above described rotationally symmetric components, odd symmetric components and even symmetric components of the wavefront aberration, the standard for each of the expansion coefficients, and the standard for each of the components obtained by grouping a plurality of expansion coefficients into a plurality of groups. A space image predicted from the wavefront aberration or a resist pattern image may be used for the predetermined standard. At this time, for example, an abnormal value of linewidth, the TFD (flatness of field) or the like in the space image may be used.

When the judgment result in step S38 is "NO", it is judged by the processing apparatus 86 whether the wavefront aberration and distortion outside the standard can be adjusted to within the standard by adjusting the spaces between the split lens-barrels 30a to 30e (step S40). When the judgment result is "YES", an instruction for adjusting the spaces between the split lens-barrels 30a to 30e is output to the assembly apparatus, so that the assembly apparatus adjusts the spaces between the split lens-barrels 30a to 30e based on this instruction, and performs decentering of the split lens-barrels 30a to 30e with respect to the optical axis AX, rotation of a predetermined optical member incorporated in the split lens-barrels 30a to 30e, and replacement of the glass plate 8, as required (step S42). The reason why the glass plate 8 is replaced by a glass plate having a different radius of curvature is for adjusting the distortion of the image plane occurring in the projection optical system PL by satisfying the Petzval's condition. After having finished step S43, control returns to step S30, to perform measurement of the wavefront aberration and the like. In this embodiment, the spaces between and eccentricity of the split lens-barrels are adjusted. However, in the adjustment of the spaces between and eccentricity of the split lens-barrels in step S40, if correction of aberration is not possible, the step of adjusting the spaces between and eccentricity of a plurality of optical members (lens and the like) housed in the split lens-barrel respectively independently is executed, and then control may proceed to step S46 described later.

These steps S30 to S42 are steps for determining how much the optical performance of the projection optical system PL can be improved, without forming an aspheric surface in the optical member in the projection optical system PL. On the other hand, in step S40, when only the adjustment of spaces between the split lens-barrels 30a to 30e is to be carried out, and if it is judged that correction of the wavefront aberration and distortion judged to be outside of the standard is not possible (when the judgment result in step S40 is "NO"), control shifts to a step for calculating the aspherical shape for correcting the aberration (steps S44 and S46), a step for forming the aspheric surface on a predetermined optical member (step S50), and a step for installing the optical member having the aspheric surface formed thereon in the projection optical system PL (step S52).

In step S44, the wavefront aberration (or respective components of wavefront aberration) and distortion after the space adjustment and eccentricity adjustment of the split lens-barrels 30a to 30e have been performed are predicted by simulation. Specifically, the calculated values of respective components of the wavefront aberration and the measured value of distortion are designated as a starting point, and optimized the space adjustment quantity and eccentricity adjustment quantity of the split lens-barrels 30a to 30e as the parameters, to thereby obtain the aberration (wavefront aberration and distortion) of the optimized projection optical system PL. An aspheric shape that can correct the simulated residual aberration (aberration of the projection optical system PL after having been optimized in step S44) is calculated (step S46).

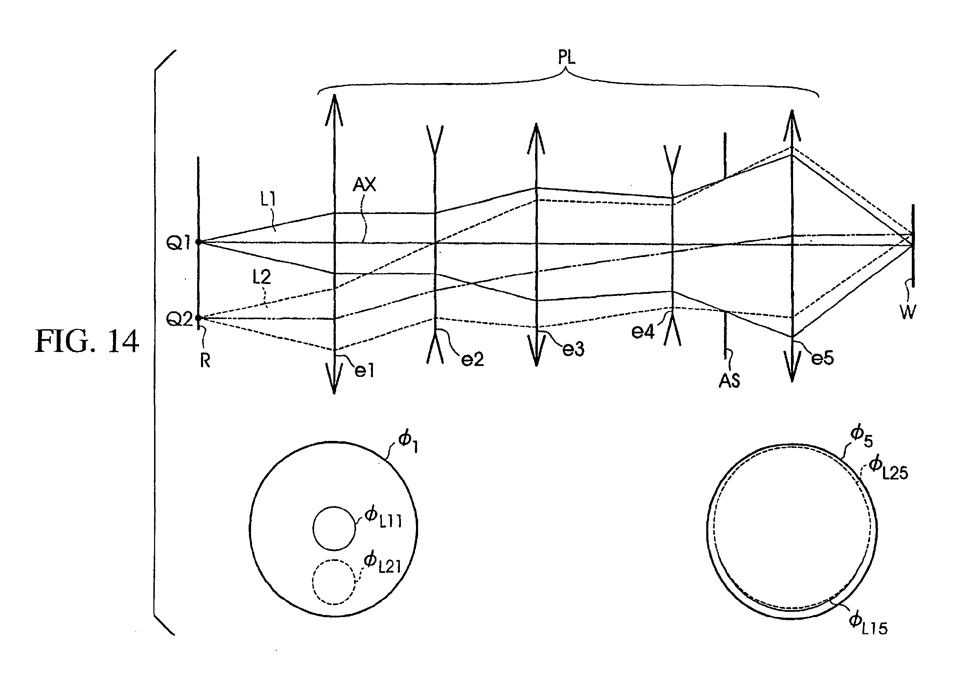

In step S46, at least two optical members are selected on which the aspheric surface is formed according to the aberration to be corrected. FIG. 14 is a diagram for explaining the optical member where the aspheric surface is formed. The projection optical system PL shown in FIG. 14 comprises, in order from the reticle side R, with the illustration thereof simplified; an optical member e1 having a positive refracting power, an optical member e2 having a negative refracting power, an optical member e3 having a positive refracting power, an optical member e4 having a negative refracting power, an aperture stop AS, and an optical member e5 having a positive refracting power.

Here, the optical path when the light from two different object points Q1 and Q2 on the reticle R passes through the projection optical system PL is considered. Reference symbol L1 in the figure denotes an optical path of beams emitted from the object point Q1, and reference symbol L2 denotes an optical path of beams emitted from the object point Q2. The beam from the object point Q1 located at an intersection between the optical axis AX of the projection optical system PL and the reticle R diverges or converges symmetrically with respect to the optical axis AX, every time the beam passes through the optical members e1 to e5, and forms an image at an intersection between the optical axis AX and the wafer W. Here, it is assumed that the clear apertures of the optical members e1 to e5 are $\phi1$ to $\phi5$. Also, it is assumed that the beam diameter of the beam L1 when the beam passes through the respective optical members e1 to e5 is $\phi L11$ to $\phi L15$, and the beam diameter of the beam L2 when the beam passes through the respective optical members e1 to e5 is $\phi L21$ to $\phi L25$.

Considering the optical path when the beams L1 and L2 pass through the optical member e1, the ratio of the beam diameter $\phi L11$ to the clear aperture $\phi$ of the optical member e1, and the ratio of the beam diameter $\phi L21$ to the clear aperture $\phi1$ of the optical member e1 is about 0.25, and the position where the beam L1 passes through the optical member e1 is different from the position where the beam L2 passes through the optical member e1. Moreover, considering the optical path when the beams L1 and L2 pass through the optical member e5, the ratio of the beam diameter $\phi L15$ to the clear aperture $\phi5$ of the optical member e5, and the ratio of the beam diameter $\phi L25$ to the clear aperture $\phi5$ of the optical member e5 is a value close to 1, and the position where the beam L1 passes through the optical member e5 and the position where the beam L2 passes through the optical member e5 are substantially the same.

Therefore, when the aspheric surface of the optical member in the projection optical system PL is calculated in step S46, it is necessary to select the optical member that can effectively correct the aberration, taking into consideration the transmission path of the beam described with reference to FIG. 14. For example, when aberration (distortion, field curvature, and the like) having high dependency on the field coordinates is to be corrected, if an aspheric surface is provided on an optical surface (lens surface, reflecting surface or the like) of the optical member e1 where the beam L1 from the object point Q1 and the beam L2 from the object point Q2 pass at separated positions, the aberration having high dependency on the field coordinates can be effectively corrected. Moreover, when aberration having high dependency on the pupil coordinates (for example, spherical aberration, eccentric coma aberration or the like) is to be corrected, if an aspheric surface is provided on an optical surface of the optical member e5 where the beam L1 from the object point Q1 and the beam L2 from the object point Q2 pass substantially the whole surface, the aberration having high dependency on the pupil coordinates can be effectively corrected.

Concerning the aberration having substantially equal dependency on the field coordinates and on the pupil coordinates (for example, coma aberration), if the aspheric surface is provided on an optical surface of the optical member where the degree of superimposition of the beam L1 from the object point Q1 and the beam L2 from the object point Q2 becomes intermediate (for example, optical member e2), the aberration having substantially equal dependency on the field coordinates and on the pupil coordinates can be effectively corrected. Therefore, in step S46, being an aspherical shape calculating step, it is desirable to calculate the aspherical shape relating to the optical surface of at least three optical members, of the plurality of optical members e 1 to e5 in the projection optical system PL. In order to effectively correct the aberration having substantially equal dependency on the field coordinates and on the pupil coordinates, such as coma aberration, it is desirable to calculate an aspherical shape relating to the optical surface of two optical members in which the degree of superimposition of the beam L1 from the object point Q1 and the beam L2 from the object point Q2 becomes intermediate. As a result, in step S46, it is further desirable to calculate the aspherical shape relating to the optical surface of at least four optical members, of the plurality of optical members e1 to e5 in the projection optical system PL.

The aspheric surface to be formed on the optical members e1 to e5 may be symmetric or asymmetric with respect to the optical axis AX. Moreover, the aspheric surface may be formed irregularly (at random) corresponding to the generated aberration. The aspheric surface calculated in step S46 is not necessarily limited to the purpose of correcting all the wavefront aberrations remaining in the projection optical system PL, but may be for correcting only a specific residual aberration. For example, the wavefront aberration that can be corrected by the external adjustment mechanism described later may not be corrected in step S46, but corrected by the external adjustment mechanism. Furthermore, of the residual wavefront aberrations of the projection optical system PL, those that can be ignored, taking the imaging performance into consideration, need not be corrected by forming the aspheric surface.

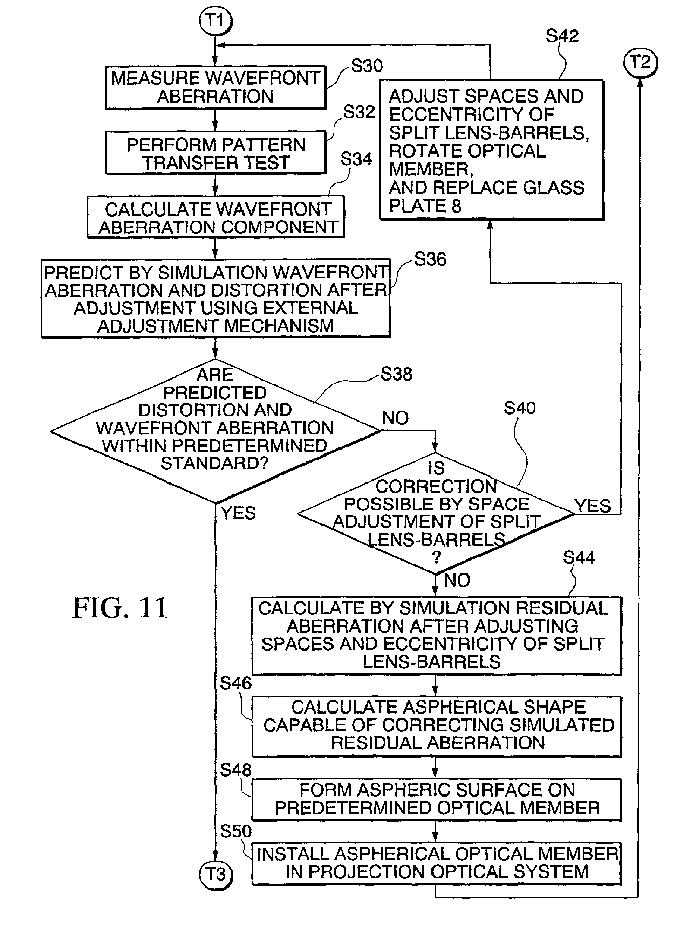

Returning to FIG. 10 and FIG. 11, in step S48, the optical surface of the optical member selected in step S46 is machined (polished) so as to obtain the aspherical shape calculated in step S46. Control then shifts to step S50, to reinstall the optical member machined so as to have the aspheric surface, into the projection optical system PL. When the aspheric surface is formed, the optical member which is machined to have the aspheric surface is taken out from the split lens-barrels 30a to 30e and machined, and then the optical member is reinstall into the position from where it has been taken out. Here, it is considered that a reinstallation error may occur again, but it is also considered that the installation error occurring here is not so large as to be unmeasurable by the aberration measuring apparatus shown in FIG. 7. Therefore, after step S50, control returns to step S20 shown in FIG. 10.

In step S38, when the predicted wavefront aberration and distortion are within the predetermined standard (when the judgment result is "YES"), this is the case where the optical characteristics of the projection optical system PL are adjusted to such a degree that the optical characteristics can be finely adjusted by the external adjustment mechanism. Therefore, the external adjustment mechanism is fitted and the initial adjustment thereof is carried out (step S52). In the projection optical system PL in this embodiment, there is provided the external adjustment mechanism that finely adjusts the optical characteristics even after production of the projection optical system PL is finished. The external adjustment mechanism herein stands for the adjusting members 32a to 32e, the parallel plate drive 35 and the glass plate 8 shown in FIG. 1. In other words, the position of the predetermined optical member in the direction of the optical axis AX and the tilt thereof with respect to a plane orthogonal to the optical axis AX can be finely adjusted, and the position (eccentricity) thereof in a plane perpendicular to the optical axis AX can be finely adjusted, by the adjusting member 32a. Moreover, the rotation of the optical member having the toric plane formed thereon about the optical axis AX can be adjusted. The eccentric coma aberration can also be adjusted by changing the tilt angle of the plane parallel plate 6 with respect to a plane orthogonal to the optical axis AX, using the parallel plate drive 35. Furthermore, the projection optical system PL can be adjusted so as to satisfy the Petzval's condition, by changing the glass plate 8 without disassembling the projection optical system PL.

In the initial adjustment of the external adjustment mechanism, processing for adjusting the response quantity of the adjusting members 32a to 32e with respect to the control signal from the lens controller section 29 (see FIG. 1) is mainly performed. Specifically, for example, when a control signal instructing extension by 1 $\mu$m is output from the lens controller 28 to the adjusting members 32a to 32e, the adjusting members 32a to 32e may not be extended as per the control signal. In this case, the response quantity of the adjusting members 32a to 32e with respect to the control quantity by the lens controller 29 is adjusted. Here, the control signal output from the lens controller 29 is a signal that can change the optical performance of the projection optical system PL, that is, the initial adjustment is a processing for determining the correlation between the adjusted quantity by the external adjustment mechanism and the changed quantity of the performance of the projection optical system PL. When the adjusting members 32a to 32e are fitted, the space adjustment between the split lens-barrels 30a to 30e using the assembly apparatus is not carried out, and only the adjustment using the external adjustment mechanism is conducted.

When the above step is finished, the wavefront aberration measurement is performed using the wavefront aberration measuring apparatus shown in FIG. 8 (step S54), similar to the steps S30 to S34, and an image of a predetermined pattern (for example, an ideal grating) is transferred onto the wafer W through the projection optical system PL (step S56). The Zernike's cylinder function system Zn ($\rho$, $\theta$) is fitted to the measurement result in step S54 to obtain the expansion coefficient Cn (Zernike coefficient) for each term, and the processing for calculating the wavefront aberration component is carried out (step S58). Also in this step, similar to the step S34, the distortion values relating to the second term and the third term according to the expansion coefficients C2 and C3 are controlled separately from the values of respective components of the wavefront aberration (the expansion coefficient C4 and thereafter). In this case, the values of the second term and the third term according to the expansion coefficients C2 and C3 are determined from the result of transferring the predetermined pattern in step S54 and the wavefront aberration determined by the expansion coefficients of the expansion coefficient C4 and thereafter calculated in step S56, and the accurate wavefront aberration is expressed by the Zernike polynomial, and this wavefront aberration component (of the expansion coefficient C2 and thereafter) may be used. When the above processing is finished, it is judged whether the wavefront aberration and distortion are within the predetermined standard (step S60).

When the judgment result in step S60 is "NO", the adjusting members 32a to 32e are used to adjust the attitude of the optical members (including the position of the optical member in the direction of the optical axis AX, the position (eccentricity) thereof in the plane orthogonal to the optical axis AX, the rotational position thereof about the axis orthogonal to the optical axis AX, and the rotational position thereof about the optical axis AX), and as required, the tilt angle of the plane parallel plate 6 is adjusted, and the glass plate 8 is replaced (step S62). On the other hand, when the judgment result in step S60 is "YES", production of the projection optical system PL is completed.

The production method for a projection optical system in one embodiment of the present invention has been described above. In step S62 in the above embodiment, the optical member closest to the reticle R may be machined to have an aspheric surface, to thereby correct the aberration (particularly, distortion) remaining in the projection optical system PL. Moreover, in step S62, the residual aberration may be corrected, utilizing dispersion of the projection optical system PL, by making the wavelength suitable for the projection optical system PL variable and setting the wavelength to a different wavelength. The distortion and spherical aberration may be corrected by adjusting the position of the reticle R in the direction of the optical axis AX and the tilt thereof with respect to the optical axis AX of the projection optical system PL. The focal position (best imaging position) of the projection optical system PL occurring due to the adjustment of the optical member in the projection optical system PL may be adjusted, by adjusting the position of the wafer W in the direction of the optical axis AX of the projection optical system PL. Furthermore, transverse deviation (image shift) of an image projected from the projection optical system PL may be corrected by adjusting the position of the wafer stage in a plane perpendicular to the optical axis AX of the projection optical system PL, and tilt (image tilt) of the image projected from the projection optical system PL may be corrected by adjusting the tilt angle of the wafer stage with respect to the optical axis AX of the projection optical system PL.

The amount that can be changed or members that can be replaced for adjusting the optical characteristics, such as wavefront aberration, of the projection optical system PL produced by the production method for a projection optical systems according to the one embodiment of the present invention described above are collectively shown below.

[1] Position of optical members in the projection optical system PL in the direction of the optical axis AX, and the inclination thereof with respect to the optical axis AX
[2] Tilt of the plane parallel plate 6 with respect to the optical axis AX
[3] Thickness and radius of curvature of the glass plate 8
[4] Position of the reticle R in the direction of the optical axis AX, and the inclination thereof with respect to the optical axis AX
[5] Wavelength of the illumination light IL
[6] Position of the wafer stage in the direction of the optical axis AX, the inclination thereof with respect to the optical axis AX, and the position of the wafer stage in a plane perpendicular to the optical axis AX

[Modified Example of Projection Optical System and Specific Example of External Adjustment Mechanism]

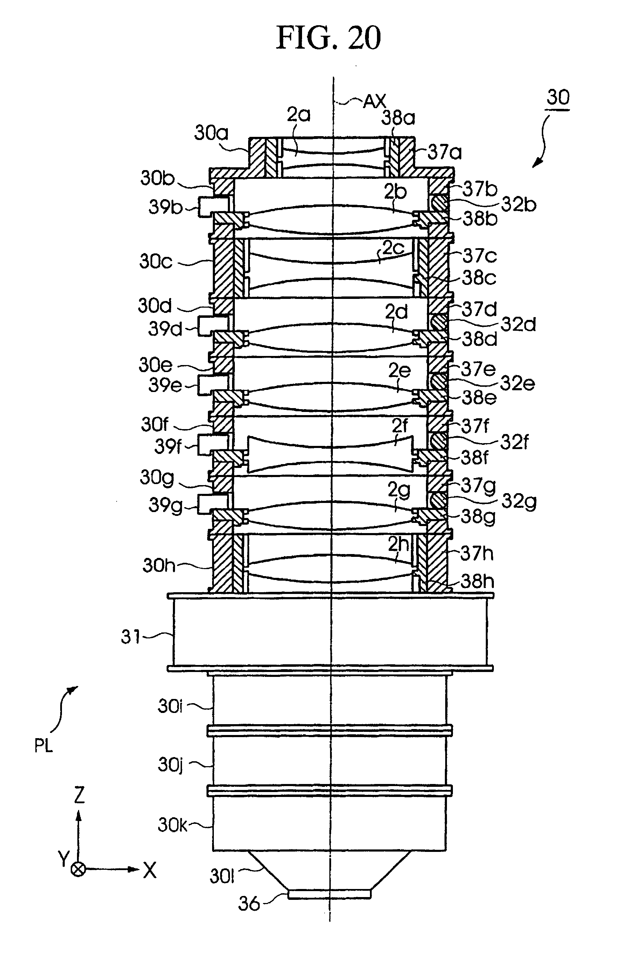

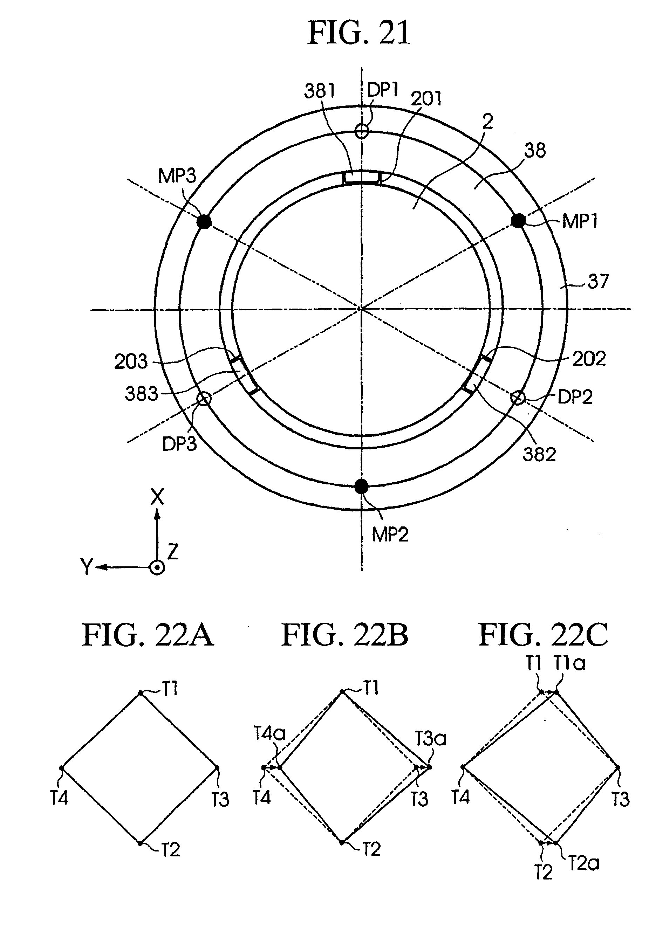

A modified example of the projection optical system and the specific example of the external adjustment mechanism will be described below. FIG. 20 is a diagram showing a schematic configuration of the projection optical system according to a modified example of the embodiment of the present invention, included in the exposure apparatus according to the one embodiment of the present invention. FIG. 21 is a top view showing one of the split lens-barrels in the projection optical system according to the modified example. In FIG. 20 and FIG. 21, the positions of respective members are described by setting an XYZ rectangular coordinate system similar to that shown in FIG. 1.

As shown in FIG. 20, a lens-barrel 30 comprises a plurality of split lens-barrels 30a to 30l, and supported by a frame of an exposure apparatus (not shown) through a flange 31. The plurality of split lens-barrels 30a to 30l are laminated in the direction of the optical axis AX. In this modified example, lenses 2b, 2d, 2e, 2f and 2g supported by the split lens-barrels 30b, 30d, 30e, 30f and 30g, of the plurality of split lens-barrels 30a to 30l are movable lenses that can be shifted in the direction of the optical axis AX (in the Z direction) and can be tilted (tiltable), with the X direction and the Y direction as an axis. The configuration of the split lens-barrels 30b, 30d, 30e, 30f and 30g holding the lenses 2b, 2d, 2e, 2f and 2g will be described, using the configuration of the split lens-barrel 30b as a representative example. The configuration of other split lens-barrels 30d, 30e, 30f and 30g is the same as that of the split lens-barrel 30b, and hence the explanation thereof is omitted.

The split lens-barrel 30b comprises an outside ring 37b connected to the split lens-barrels 30a and 30c located above and below the split lens-barrel 30b (Z direction), and a lens chamber 38b for holding the lens 2b. The lens chamber 38b is connected to the outside ring 37b, so as to be movable in the direction of the optical axis (Z direction) with respect to the outside ring 37b and tiltable about an axis parallel to the X-axis or parallel to the Y-axis. The split lens-barrel 30b comprises an actuator 32b fitted to the outside ring 37b. For this actuator 32b, for example, a piezoelectric element can be applied. The actuator 32b drives the lens chamber 38b through a link mechanism as a displacement enlarging mechanism constituted of for example a resilient hinge. The actuator 32b is fitted at three points of the split lens-barrel 30b, and as a result, the three points of the lens chamber 38 independently move in the direction of the optical axis (Z direction).

This structure will be described below in detail, with reference to FIG. 21. In the explanation below, when specifying any of the split lens-barrels 30b, 30d, 30e, 30f and 30g and the respective members constituting these split lens-barrels without discriminating these, the signs "a" to "g" attached at the end of the reference symbol are omitted. In FIG. 21, three projections 201 to 203 are provided on the rim of the lens 2, for each azimuth of 120° in the XY plane. The lens chamber 38 comprises clamp portions 381 to 383, which hold the three projections 201 to 203 of the lens 2. The lens chamber 38 is driven independently at positions of driving points DP1 to DP3 for each azimuth of 120° in the XY plane, along the Z direction through the link mechanism by the three actuators (not shown).

When the driven quantity in the Z direction by the three actuators is the same, the lens chamber 38 moves in the Z direction (in the direction of the optical axis) with respect to the outside ring 37. When the driven quantity in the Z direction by the three actuators is different, the lens chamber 38 tilts about the axis parallel to the X-axis or parallel to the Y-axis, with respect to the outside ring 37. When the driven quantity in the Z direction by the three actuators is different, the lens chamber 38 may shift in the Z direction (in the direction of the optical axis) with respect to the outside ring 37.

Returning to FIG. 20, the split lens-barrel 30b comprises a driven quantity measuring section 39b consisting of, for example, an optical encoder, fitted to the outside ring 37b. The driven quantity measuring section 39b measures the shift quantity of the lens chamber 38b in the Z direction (in the direction of the optical axis) with respect to the outside ring 37, at positions of three measuring points MP 1 to MP3 for each azimuth of 120° shown in FIG. 21. Therefore, the shift of the lens chamber 38b and the shift of the lens 2b can be controlled by a closed loop, by the actuator 32b and the driven quantity measuring section 39b. The actuator 32b, the driven quantity measuring section 39, and the lens chamber 38 provided in the split lens-barrels 30b, 30d, 30e, 30f and 30g constitute a part of the external adjustment mechanism in the present invention.

The lenses 2a, 2c, 2h, 2i, 2j, 2k and 2l supported by the split lens-barrels 30a, 30c, 30h, 30i, 30j, 30k and 30l, of the split lens-barrels 30a to 30l shown in FIG. 20 are fixed lenses. The configuration of the split lens-barrels 30a, 30c, 30h, 30i, 30j, 30k and 30l which hold these fixed lenses 2a, 2c, 2h, 2i, 2j, 2k and 2l will be described, using the configuration of the split lens-barrel 30c. The configuration of other split lens-barrels 30a, 30h, 30i, 30j, 30k and 30l other than the split lens-barrel 30c is substantially the same as that of the split lens-barrel 30c, and hence the explanation thereof is omitted. The split lens-barrel 30c comprises an outside ring 37c connected to the split lens-barrels 30b and 30d located above and below the split lens-barrel 30c (Z direction), and a lens chamber 38c fitted to the outside ring 37c for holding the lens 2c.

In this modified example, a piezoelectric element having high accuracy, low generation of heat, high rigidity and high cleanness is used for the actuator 32, and the driving force of the piezoelectric element is increased by a link mechanism consisting of a resilient hinge. As a result, there is an advantage in that the piezoelectric element itself can be made compact. Instead of constituting the actuator 32 by the piezoelectric element, the actuator 32 may be constituted of a magnetostrictive actuator or a hydrostatic pressure actuator. The lenses 2a to 2l may be formed of a single lens element, or may be formed of a lens group combining a plurality of lens elements.

In the projection optical system PL having the above configuration, the attitude of the lenses 2b, 2d, 2e, 2f and 2g can be changed without changing the attitude (position in the direction of the optical axis AX and tilt with respect to the XY plane) of the lenses 2a, 2c, 2h, 2i, 2j, 2k and 2l. Five rotationally symmetric aberrations and five eccentric aberrations occurring in the projection optical system PL can be independently corrected, by adjusting the attitude of one lens of these lenses or by adjusting the attitudes of a plurality of lenses associated with each other, by the external adjustment mechanism.

Five rotationally symmetric aberrations referred to herein stand for magnification, distortion (distortion aberration), coma aberration, field curvature aberration and spherical aberration. Five decentration aberrations stand for decentration distortion (distortion aberration), eccentric coma aberration, decentration astigmatism aberration and decentration spherical aberration. However, for the decentration distortion referred to herein, there are two kinds as shown in FIGS. 22A to C. These figures are for explaining the two kinds of decentration distortion. A case where a rectangular image having four apexes T1 to T4 shown in FIG. 22A is distorted in the rightward direction in the figure due to the eccentric distortion is considered.

FIG. 22B and FIG. 22C shows the state in which the image shown in FIG. 22A is distorted due to the eccentric distortion. In either case of the example shown in FIG. 22B and the example shown in FIG. 22C, the rectangular image is deformed in a shape pulled rightward in the figure due to eccentric distortion. In the example shown in FIG. 22B, the positions of apexes T1 and T2, of the four apexes T1 to T4, are not changed, but the apexes T3 and T4 are displaced to the positions denoted by reference symbols T3a and T4a. As a result, the image is deformed in a quadrangle shape obtained by connecting the apexes T1, T2, T3a and T4a by straight lines.

On the other hand, in the example shown in FIG. 22C, the positions of apexes T3 and T4 are not changed, but the apexes T1 and T2 are displaced to the positions denoted by reference symbols T1a and T2a. As a result, the image is deformed in a quadrangle shape obtained by connecting the apexes T1a, T2a, T3 and T4 by straight lines. As described above, there are two kinds of eccentric distortion. In the projection optical system PL shown in FIG. 20, both eccentric distortions can be independently corrected by adjusting the attitude of the lenses 2b, 2d, 2e, 2f and 2g.

The amount that can be changed or members that can be replaced for adjusting the optical characteristics, such as wavefront aberration, of the projection optical system PL shown in FIG. 20 are coordinated in the same manner as for the projection optical system shown in FIG. 1 and collectively shown below

[1] Position of optical members (lenses 2b, 2d, 2e, 2f and 2g) in the projection optical system PL in the direction of the optical axis AX, and the inclination thereof with respect to the optical axis AX

[2] Tilt of the plane parallel plate 6 with respect to the optical axis AX

[3] Thickness and radius of curvature of the glass plate 8

[4] Position of the reticle R in the direction of the optical axis AX, and the inclination thereof with respect to the optical axis AX

[5] Wavelength of the illumination light IL

[6] Position of the wafer stage in the direction of the optical axis AX, the inclination thereof with respect to the optical axis AX, and position of the wafer stage in a plane perpendicular to the optical axis AX

The external adjustment mechanism included in the projection optical system PL shown in FIG.20 is used for correcting the performance change of the projection optical system PL resulting from environmental changes such as atmospheric pressure and temperature, or irradiation fluctuation, when exposure processing is conducted after the projection optical system PL is installed in the exposure apparatus. Conventionally, these corrections are performed by controlling the attitude of specific two optical members on the reticle R side in the projection optical system PL, or changing the atmospheric pressure in the projection optical system. In the conventional correction method, however, freedom in correction is little, and aberration that can be corrected is limited to specific aberration such as distortion and eccentric coma aberration. Since the projection optical system PL shown in FIG. 20 can freely control the attitude of the respective lenses 2b, 2d, 2e, 2f and 2g, freedom in correction and adjustment is high, and the aberrations that can be corrected are as many as five rotationally symmetric aberrations and five eccentric aberrations described above, and hence this is highly suitable for forming minute patterns on the wafer W.

Recently, with microfabrication of the pattern, deformed illumination is frequently used, in which the illumination condition of the illumination light IL is changed by applying a superresolution technique. The deformed illumination is zone deformed illumination or illumination in which the coherency σ of illumination (σ value = numerical aperture on the exit side of the illumination optical system / numerical aperture on the incidence side of the projection optical system) is changed, or multipolar illumination in which the illumination light is divided in a multipolar form (for example, four poles or two poles). There is also a case where the numerical aperture on the emission side of the projection optical system PL is changed according to the illumination condition. With the external adjustment mechanism included in the projection optical system PL shown in FIG.20, the attitude of the respective lenses 2b, 2d, 2e, 2f and 2g can be freely controlled according to the set illumination condition or the numerical aperture on the emission side of the projection optical system PL, to thereby set the optical characteristics of the projection optical system PL corresponding to the illumination condition or the like.

[Production Method for Exposure Apparatus]

The exposure apparatus (FIG. 1) according to the one embodiment of the present invention is produced by assembling and coupling electrically, mechanically or optically, each component shown in FIG. 1, such as the light source 12 and the illumination optical system 14, the reticle alignment system including the reticle stage 16 and a movable mirror and an interferometer (not shown), the wafer alignment system including the wafer stage 18, the wafer holder 19, the wafer stage control system 24, the laser interferometer 26 and the movable mirror 28, and the projection optical system PL, and then performing integrated adjustment (electrical adjustment, operation checking, etc.) so that position control of the wafer W can be performed accurately and at a high speed, and exposure becomes possible with high exposure accuracy, while improving the throughput. When producing the exposure apparatus, there are provided processes for preparing the projection optical system PL produced by the production method for a projection optical system described above, preparing the reticle stage 16 for positioning the reticle on the object plane (first plane) of the projection optical system PL, and preparing the wafer stage 18 for positioning the wafer W on the image plane (second plane) of the projection optical system PL. The production of the exposure apparatus is desirably executed in a clean room where the temperature and the cleanness are controlled.

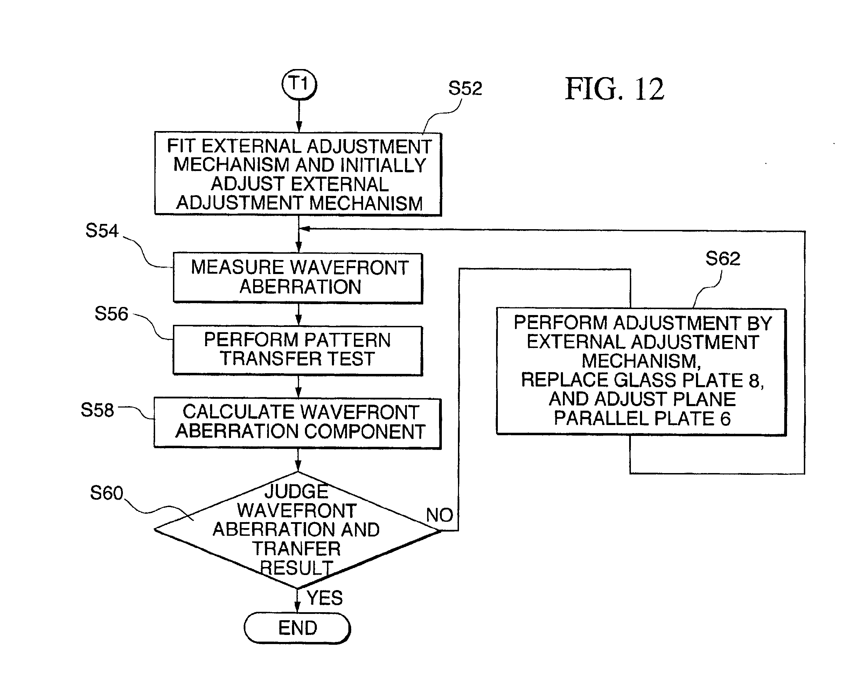

In the production method for a projection optical system described above, explanation has been given for a case in which after the external adjustment mechanism such as the adjusting members 32a to 32e shown in FIG. 1 is fitted, the final adjustment is performed to produce the projection optical system PL. However, after executing the step for fitting the external adjustment mechanism to the projection optical system PL (step S52 in FIG. 12), the projection optical system PL may be installed in the exposure apparatus, and then the final adjustment (steps S54 to S62 in FIG. 12) may be executed. In this case, by changing the wavelength of the illumination light IL from the illumination optical system 14 included in the exposure apparatus to obtain a wavelength suitable for the projection optical system PL, the residual aberration is corrected, utilizing dispersion of the projection optical system PL. The correction of distortion and spherical aberration by adjusting the attitude of the reticle R with respect to the optical axis AX is performed by controlling the attitude of the reticle stage 16 shown in FIG. 1, and correction of the deviation from the best imaging position, image shift and image tilt by adjusting the attitude of the wafer W, is performed by controlling the attitude of the wafer stage 18.

[Production Method for Microdevices]

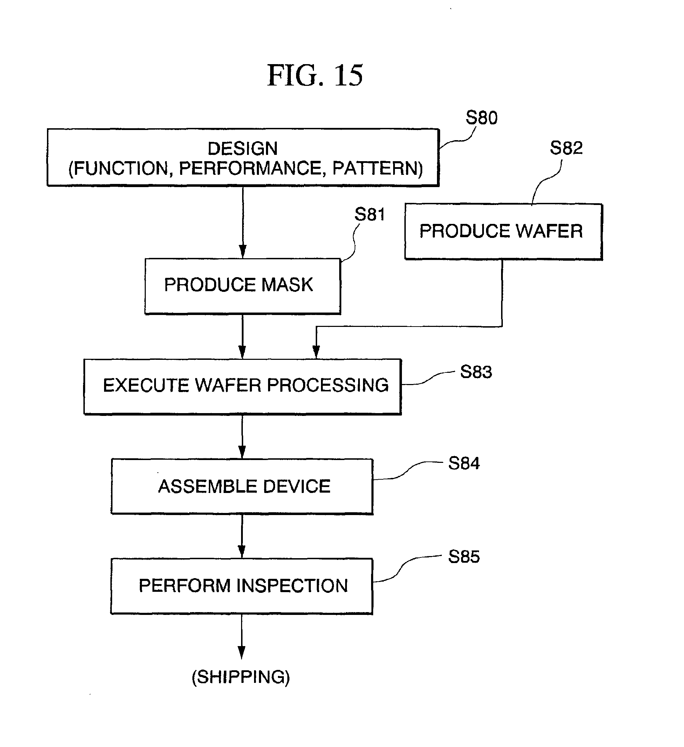

The production method for microdevices according to the one embodiment of the present invention, in which the exposure apparatus according to the one embodiment of the present invention is used in the lithography process, will be described below. FIG. 15 is a flowchart showing a production example for microdevices (semiconductor chips such as IC and LSI, liquid crystal panels, CCDs, thin film magnetic heads, micromachines, etc.). As shown in FIG. 15, in step S80 (design step), functional and performance design of the microdevice (for example, circuit design or the like of the semiconductor device) is performed, and pattern design to perform the desired function. Subsequently, in step S81 (mask production step), a mask (reticle) on which the designed circuit pattern is formed is produced. On the other hand, in step S82 (wafer production step), wafers are produced, using materials such as silicon.

Then, in step S83 (wafer processing step), an actual circuit or the like is formed on the wafer by the lithographic technique, using the mask and the wafer prepared in step S80 to step S82. In step S84 (device assembly step), the wafer processed in step S83 is used to perform device assembly. This step S84 includes steps such as a dicing step, a bonding step, and a packaging step (chip mounting), as required. Lastly, in step S85 (inspection step), inspections such as operation confirmation tests of the microdevice, durability tests and the like of the microdevices manufactured in step S84 are carried out. The microdevices are then completed after passing through these steps, and shipped.

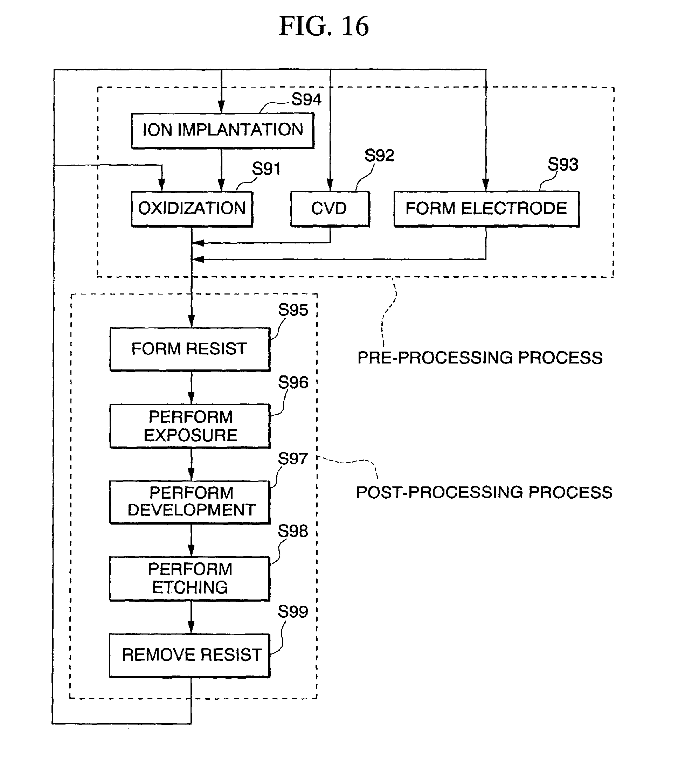

FIG. 16 is a diagram showing one example of the detailed flow in step S83 shown in FIG. 15, in the case of a semiconductor device. In FIG. 16, the surface of the wafer is oxidized in step S91 (oxidation step). In step S92 (CVD step), an insulation film is formed on the surface of the wafer. In step S93 (electrode forming step), an electrode is formed on the wafer by vapor deposition. In step S94 (ion implantation step), ions are implanted in the wafer. These steps S91 to S94 form a pre-processing process in respective stages of wafer processing, respectively, and are selected according to necessary processing in the respective stages, and executed.

In the respective stages of the wafer process, when the pre-processing process is finished, the post-processing process is executed as described below. In this post-processing process, in step S95 (resist forming step), a photosensitizer is applied on the wafer. In step S96 (exposure step), a circuit pattern of a mask is transferred to the wafer by the lithography system (exposure apparatus) and the exposure method. In step S97 (development step), the exposed wafer is developed, and in step S98 (etching step), exposure members other than the portions where the resist remains are removed by etching. In step S99 (resist removal step), the resist which becomes unnecessary after the etching step is removed. By repeating these pre-processing process and the post-processing process, the circuit pattern is formed in multiple layers on the wafer.

One embodiment of the present invention has been described, but the present invention is not limited thereto, and can be freely modified within the scope of the present invention. For example, in the above embodiment, a step and repeat type exposure apparatus has been described as an example, but the present invention is also applicable to a step and scan type exposure apparatus. For the light source of the illumination optical system in the exposure apparatus in this embodiment, an excimer laser light source which supplies beams having a wavelength of 248 nm (KrF) or 193 nm (ArF) is exemplified. However, the present invention is not limited thereto, and ultraviolet rays such as a g ray (436 nm) and an i ray (365 nm) emitted from an extra-high pressure mercury lamp, and laser beams in a vacuum ultraviolet region emitted from an $F_2$ laser (157 nm) may be used. For example, when an electron beam is used, thermionic emission type lanthanum hexaboride ($LaB_6$) and tantalum (Ta) may be used as an electron gun. In the above described embodiment, the present invention is applicable not only to an exposure apparatus used for producing semiconductor devices and liquid crystal display devices, but also to an exposure apparatus used for producing thin film magnetic heads for transferring the device pattern onto a ceramic wafer, and an exposure apparatus used for producing image pickup devices such as CCD.

In order to manufacture reticles or masks used for not only the microdevices such as semiconductor devices, but also optical exposure apparatus, EUV exposure apparatus, X-ray exposure apparatus and electron beam exposure apparatus, the present invention is applicable to exposure apparatus which transfer a circuit pattern from a mother reticle to a glass substrate, a silicon wafer and the like. Here, in the exposure apparatus using DUV (deep ultraviolet) and VUV (vacuum ultraviolet) beams, a transmission type reticle is generally used, and for the reticle substrate, silica glass, silica glass doped with fluorine, fluorite, magnesium fluoride or crystal is used. In the X-ray exposure apparatus and electron beam exposure apparatus, a transmission type mask (stencil mask, membrane mask) is used, and a silicon wafer or the like is used for the mask substrate. Such exposure apparatus are proposed in European Patent Application No. 1043625, European Patent Application No. 1083462, US Patent Application No. 736423 (filed on December 15, 2000), Japanese Unexamined Patent Application, First Publication Nos. Hei 11-194479, 2000-12453 and 2000-29202. The disclosures in European Patent Application No. 1043625, European Patent Application No. 1083462 and US Patent Application No. 736423 are hereby incorporated by reference.

In the above embodiment, a projection optical system having a common optical axis along one straight line (direct cylinder type projection optical system) has been described as an example, but the present invention is also applicable to a cata-dioptric type projection optical system having a plurality of optical axes, as proposed for example in US Patent No. 6,195,213 and US Patent Application No.769832 (filed on January 26, 2000). The disclosures in US Patent No. 6,195,213 and US Patent Application No.769832 are hereby incorporated by reference.

**Claims**

1. A production method for a projection optical system for forming an image first plane on a second plane, comprising:

    an assembly step for obtaining a projection optical system by assembling a plurality of barrels having one or a plurality of optical members respectively housed therein;
    a wavefront aberration measuring step for measuring wavefront aberration of said assembled projection optical system;
    a wavefront aberration component calculating step for making said wavefront aberration measured by said wavefront aberration measuring step correspond to a predetermined function, and calculating respective components of the wavefront aberration by resolving components of said function, and
    an adjusting step for adjusting said plurality of barrels corresponding to the respective components of the wavefront aberration obtained by said wavefront aberration component calculating step.

2. A production method for a projection optical system for forming an image on a first plane on a second plane, comprising:

    an assembly step for obtaining a projection optical system by assembling a plurality of optical members;
    a wavefront aberration measuring step for measuring wavefront aberration of said projection optical system;
    a wavefront aberration component calculating step for making said wavefront aberration measured by said wavefront aberration measuring step correspond to a predetermined function, and calculating respective components of the wavefront aberration by resolving the components of said function;
    a first and second adjusting step for adjusting said plurality of optical members corresponding to the respective components of the wavefront aberration obtained by said wavefront aberration component calculating step,
    a performance prediction step executed prior to said second adjusting step for predicting the performance after the adjustment in said second adjusting step; and
    a judging step executed between said performance prediction step and said second adjusting step for judging the performance of said projection optical system based on the performance predicted in said performance prediction step.

3. A production method for a projection optical system according to claim 2, wherein

said wavefront aberration measuring step includes a first wavefront aberration measuring step executed before said first adjusting step and a second wavefront aberration measuring step executed between said first adjusting step and said judging step, and

said wavefront aberration component calculating step includes a first wavefront aberration component calculating step in which the wavefront aberration measured in said first wavefront aberration measuring step is made to correspond to said predetermined function, and a second wavefront aberration component calculating step in which the wavefront aberration measured in said second wavefront aberration measuring step is made to correspond to said predetermined function.

4. A production method for a projection optical system according to claim 3, wherein said first adjusting step includes an aspherical shape calculating step for calculating an aspherical shape that can correct residual wavefront aberration remaining after the adjustment of said optical members.

5. A production method for a projection optical system according to claim 4, wherein in said aspherical shape calculating step, an aspheric surface including a non-rotational symmetrical component with respect to the optical axis of said projection optical system is calculated.

6. A production method for a projection optical system according to claim 5, further including an aspheric surface forming step in which said aspheric surface calculated in said aspherical shape calculating step is formed on an optical surface of at least one predetermined optical member of said plurality of optical members.

7. A production method for a projection optical system according to claim 4, wherein

said aspherical shape calculating step calculates said aspherical shape in relation to the optical surfaces of at least two optical members of said plurality of optical members, and

if a diameter of light beam when the light beam from one predetermined point on the surface of an object passes through said optical surfaces is assumed to be a partial diameter of light beam, optical members having different partial diameter of light beam with respect to a clear aperture of said optical surface are selected for said at least two optical members.

8. A production method for a projection optical system according to claim 4, wherein

in said judging step, judgment of whether to shift to said aspherical shape calculating step when said projection optical system does not have a predetermined performance is performed.

9. A production method for a projection optical system according to claim 3, wherein

in said assembly step, a plurality of barrels in which one or a plurality of said optical members is respectively housed is assembled, and

in said adjusting step, said plurality of barrels are adjusted, corresponding to the respective components of the wavefront aberration obtained in said wavefront aberration component calculating step.

10. A production method for a projection optical system according to claim 2, wherein said first adjusting step includes an aspherical shape calculating step for calculating an aspherical shape that can correct residual wavefront aberration remaining after the adjustment of said optical members.

11. A production method for a projection optical system according to claim 10, wherein in said aspherical shape calculating step, an aspheric surface including a non-rotational symmetrical component with respect to the optical axis of said projection optical system is calculated.

12. A production method for a projection optical system according to claim 10, further including an aspheric surface forming step in which an aspheric surface calculated in said aspherical shape calculating step is formed on an optical surface of at least one predetermined optical member of said plurality of optical members.

13. A production method for a projection optical system according to claim 12, wherein in said judging step, judgment of whether to shift to said aspherical shape calculating step when said projection optical system does not have a predetermined performance is performed.

14. A production method for a projection optical system according to claim 10, wherein

said aspherical shape calculating step calculates said aspherical shape in relation to the optical surfaces of at least two optical members of said plurality of optical members, and

if a diameter of light beam when the light beam from one predetermined point on the surface of an object passes through said optical surfaces is assumed to be a partial diameter of light beam, optical members having different partial diameter of light beam with respect to a clear aperture of said optical surface are selected for said at least two optical members.

15. A production method for a projection optical system according to claim 10,

wherein in said judging step, judgment of whether to shift to said aspherical shape calculating step when said projection optical system does not have a predetermined performance is performed.

16. A production method for a projection optical system according to claim 10, wherein

in said assembly step, a plurality of barrels in which one or a plurality of said optical members is respectively housed is assembled, and

in said adjusting step, said plurality of barrels are adjusted, corresponding to the respective components of the wavefront aberration obtained in said wavefront aberration component calculating step.

17. A production method for a projection optical system according to claim 2, wherein said first adjusting step adjusts at least the attitude of the optical members.

18. A production method for a projection optical system according to claim 2, wherein

in said first adjusting step at least one optical member of said plurality of optical members is replaced.

19. A production method for a projection optical system according to claim 2, wherein,

in said second adjusting step an external adjustment mechanism which can adjust the performance of said projection optical system from outside of said projection optical system is used to perform adjustment.

20. A production method for a projection optical system according to claim 19, wherein

said second adjusting step includes a step for determining a correlation between an adjustment amount by said external adjustment mechanism and a variation in the performance of said projection optical system.

21. A production method for a projection optical system according to claim 20, wherein

in said assembly step, a plurality of barrels in which one or a plurality of said optical members is respectively housed is assembled, and

in said adjusting step, said plurality of barrels are adjusted, corresponding to the respective components of the wavefront aberration obtained in said wavefront aberration component calculating step.

22. A production method for a projection optical system according to claim 2, wherein

said second adjusting step performs at least either one of a supplementary step for adjusting the attitude of said optical members, and a supplementary step for replacing the optical members in the vicinity of said first plane and/or said second plane of said plurality of optical members.

23. A production method for a projection optical system according to claim 2, wherein

said second adjusting step sets the wavelength of said projection optical system.

24. A production method for a projection optical system according to claim 2, wherein

said second adjusting step includes a step for performing fine adjustment of the attitude of said second plane.

25. A production method for a projection optical system according to claim 2, wherein

in said assembly step, a plurality of barrels in which one or a plurality of said optical members is respectively housed is assembled, and

in said adjusting step, said plurality of barrels are adjusted, corresponding to the respective components of the wavefront aberration obtained in said wavefront aberration component calculating step.

26. A production method for a projection optical system for forming an image on a first plane on a second plane, comprising:

an assembly step for obtaining a projection optical system by assembling a plurality of optical members;
a wavefront aberration measuring step for measuring wavefront aberration of said assembled projection optical system;

a wavefront aberration component calculating step for making said wavefront aberration measured by said wavefront aberration measuring step to correspond to a predetermined function, and calculating respective components of the wavefront aberration by resolving the components of said function; and

an adjusting step for adjusting said plurality of optical members corresponding to the respective components of the wavefront aberration obtained by said wavefront aberration component calculating step, wherein

said adjusting step includes an aspherical shape calculation supplementary step for calculating an aspherical shape that can correct residual wavefront aberration remaining after said optical members have been adjusted, and

in said aspherical shape calculation supplementary step, said aspherical shape is calculated in relation to the optical surfaces of at least two optical members of said plurality of optical members, and

if a diameter of light beam when the light beam from one predetermined point on the surface of an object passes through said optical surface is assumed to be a partial diameter of light beam, optical members having different partial diameter of light beam with respect to a clear aperture of said optical surface are selected for said at least two optical members.

27. A production method for a projection optical system according to claim 26, wherein

in said aspherical shape calculation supplementary step, an aspheric surface including a non-rotational symmetrical component with respect to the optical axis of said projection optical system is calculated.

28. A production method for a projection optical system for forming an image on a first plane on a second plane, comprising:

an assembly step for obtaining a projection optical system by assembling a plurality of optical members;

a fitting step for fitting an external adjustment mechanism which adjusts a specific optical member of said optical members from outside, to said projection optical system;

a wavefront aberration measuring step for measuring wavefront aberration of said projection optical system;

a wavefront aberration component calculating step for making said wavefront aberration measured by said wavefront aberration measuring step correspond to a predetermined function, and calculating respective components of the wavefront aberration by resolving the components of said function; and

a fine adjustment step for finely adjusting the performance of said projection optical system by said external adjustment mechanism, corresponding to the respective components of the wavefront aberration obtained by said wavefront aberration component calculating step.

29. A production method for a projection optical system according to claim 28, wherein

said external adjustment mechanism adjusts one or a plurality of said specific optical members, to independently adjust at least three aberrations.

30. A production method for a projection optical system according to claim 28, wherein there is further included a step for determining a correlation between an adjustment amount by said external adjustment mechanism and a variation in the performance of said projection optical system.

31. A production method for a projection optical system according to claim 28, wherein

said fine adjustment step performs at least either one of a supplementary step for adjusting the attitude of said optical members, and a supplementary step for replacing the optical members in the vicinity of said first plane and/or said second plane of said plurality of optical members.

32. A production method for an exposure apparatus comprising:

a step for preparing a projection optical system produced by the production method for a projection optical system of any one of claim I through claim 31;

a step for preparing a mask stage for positioning a mask on said first plane of said projection optical system; and

a step for preparing a substrate stage for positioning a substrate on said second plane of said projection optical system.

33. A projection optical system produced by a production method according to any one of claim I through claim 31.

34. An exposure apparatus comprising a projection optical system produced by a production method for a projection optical system according to any one of claim 1 through claim 31, wherein

a pattern image of a mask positioned on said first plane is transferred onto a substrate positioned on said second plane through said projection optical system.

**35.** A production method for a microdevice comprising:

an exposure step which uses an exposure apparatus according to claim 34 for exposing a pattern of said mask on said substrate; and

a development step for developing said substrate exposed by said exposure step.

**36.** An exposure method which uses a projection optical system produced by a production method for a projection optical system according to any one of claim 1 through claim 31, to transfer a pattern image of a mask positioned on said first plane onto a substrate positioned on said second plane through said projection optical system.

# FIG. 1

# FIG. 2A

# FIG. 2B

# FIG. 3

# FIG. 4

FIG. 5

FIG. 6

EP 1 359 608 A1

# FIG. 7

# FIG. 8

EP 1 359 608 A1

# FIG. 9

START

**PROJECTION OPTICAL SYSTEM ASSEMBLING STEP** — S1

- ASSEMBLE SPLIT LENS-BARREL HOUSING ONE OR A PLURALITY OF OPTICAL MEMBERS

**WAVEFRONT ABERRATION MEASURING STEP** — S2

**WAVEFRONT ABERRATION COMPONENT CALCULATING STEP** — S3

- CALCULATE WAVEFRONT ABERRATION FROM WAVEFRONT ABERRATION MEASUREMENT RESULT AND PATTERN TRANSFER RESULT, AND EXPRESS IT USING ZERNIKE COEFFICIENT

**FIRST ADJUSTING STEP** — S4

- CALCULATE PERFORMANCE PREDICTION VALUE AFTER ADJUSTMENT BY SIMULATION
- CALCULATE BY SIMULATION ASPHERICAL SHAPE CAPABLE OF CORRECTING RESIDUAL ABERRATION
- FORM ASPHERIC SURFACE ON OPTICAL MEMBER
- ADJUST ATTITUDE OF OPTICAL MEMBER
- REPLACE OPTICAL MEMBER

**SECOND ADJUSTING STEP** — S5

- ADJUST ATTITUDE OF OPTICAL MEMBER BY EXTERNAL ADJUSTMENT MECHANISM

END

FIG. 10

```
                    ( START )
                        │
                        ▼
        ┌──────────────────────────────┐
        │  INSTRUCT INSTALLATION OF     │────── S10
        │  OPTICAL MEMBER               │
        └──────────────────────────────┘
                        │
                        ▼
        ┌──────────────────────────────┐
        │  INITIALLY ASSEMBLE           │────── S12
        │  PROJECTION OPTICAL SYSTEM    │
        └──────────────────────────────┘
                        │
                        ▼
        ┌──────────────────────────────┐
        │  MEASURE WAVEFRONT            │────── S14
        │  ABERRATION                   │
        └──────────────────────────────┘
                        │
                        ▼
                    ◇ S16                           S18
            IS IT                                ┌──────────────────────┐
      POSSIBLE TO MEASURE                        │  ADJUST SPACES AND    │
    ABERRATION AT ALL MEASURING  ──── NO ───────▶│  ECCENTRICITY OF SPLIT│
          POINTS?                                │  LENS-BARRELS BY      │
            ◇                                    │  ASSEMBLY APPARATUS   │
            │ YES                                └──────────────────────┘
            ◀──── (T2)
            │
            ▼
        ┌──────────────────────────────┐
        │  MEASURE WAVEFRONT            │────── S20
        │  ABERRATION                   │
        └──────────────────────────────┘
                        │
                        ▼
                    ◇ S22                           S24
            ARE                                  ┌──────────────────────┐
        MEASUREMENT                              │  ADJUST SPACES AND    │
  RESULT AND DISTORTION WITHIN ──── NO ─────────▶│  ECCENTRICITY OF SPLIT│
       PREDETERMINED                             │  LENS-BARRELS BY      │
         STANDARD?                               │  ASSEMBLY APPARATUS   │
            ◇                                    └──────────────────────┘
            │ YES   S26
            ▼
                    ◇                                S28
        ARE CENTER                               ┌──────────────────────┐
   ASTIGMATISM COMPONENT                         │  ROTATE TORIC OPTICAL │
   AND ANISOTROPIC DISTORTION ──── NO ──────────▶│  MEMBER               │
    WITHIN PREDETERMINED                         └──────────────────────┘
          STANDARD?
            ◇
            │ YES
            ▼
          (T1)
```

FIG. 11

(T1)

MEASURE WAVEFRONT ABERRATION — S30

PERFORM PATTERN TRANSFER TEST — S32

CALCULATE WAVEFRONT ABERRATION COMPONENT — S34

PREDICT BY SIMULATION WAVEFRONT ABERRATION AND DISTORTION AFTER ADJUSTMENT USING EXTERNAL ADJUSTMENT MECHANISM — S36

S38 — ARE PREDICTED DISTORTION AND WAVEFRONT ABERRATION WITHIN PREDETERMINED STANDARD?

YES

NO

S40 — IS CORRECTION POSSIBLE BY SPACE ADJUSTMENT OF SPLIT LENS-BARRELS?

YES

NO

S42 — ADJUST SPACES AND ECCENTRICITY OF SPLIT LENS-BARRELS, ROTATE OPTICAL MEMBER, AND REPLACE GLASS PLATE 8

(T2)

CALCULATE BY SIMULATION RESIDUAL ABERRATION AFTER ADJUSTING SPACES AND ECCENTRICITY OF SPLIT LENS-BARRELS — S44

CALCULATE ASPHERICAL SHAPE CAPABLE OF CORRECTING SIMULATED RESIDUAL ABERRATION — S46

FORM ASPHERIC SURFACE ON PREDETERMINED OPTICAL MEMBER — S48

INSTALL ASPHERICAL OPTICAL MEMBER IN PROJECTION OPTICAL SYSTEM — S50

(T3)

FIG. 12

(T1)

S52 — FIT EXTERNAL ADJUSTMENT MECHANISM AND INITIALLY ADJUST EXTERNAL ADJUSTMENT MECHANISM

S54 — MEASURE WAVEFRONT ABERRATION

S56 — PERFORM PATTERN TRANSFER TEST

S58 — CALCULATE WAVEFRONT ABERRATION COMPONENT

S60 — JUDGE WAVEFRONT ABERRATION AND TRANFER RESULT

NO

S62 — PERFORM ADJUSTMENT BY EXTERNAL ADJUSTMENT MECHANISM, REPLACE GLASS PLATE 8, AND ADJUST PLANE PARALLEL PLATE 6

YES

END

EP 1 359 608 A1

# FIG. 13A

# FIG. 13B

EP 1 359 608 A1

FIG. 14

# FIG. 15

```
                                                              S80
┌─────────────────────────────────────────┐
│              DESIGN                        │
│  (FUNCTION, PERFORMANCE, PATTERN)          │
└─────────────────────────────────────────┘
                  │                        S82
                  │          ┌──────────────────────────┐
                  │   S81    │     PRODUCE WAFER          │
                  │          └──────────────────────────┘
                  ▼                        │
        ┌──────────────────┐              │
        │  PRODUCE MASK     │              │
        └──────────────────┘              │
                  │                        │
                  ▼          ◄─────────────┘
        ┌─────────────────────────────┐   S83
        │  EXECUTE WAFER PROCESSING    │
        └─────────────────────────────┘
                  │
                  ▼
        ┌─────────────────────────────┐   S84
        │     ASSEMBLE DEVICE          │
        └─────────────────────────────┘
                  │
                  ▼
        ┌─────────────────────────────┐   S85
        │   PERFORM INSPECTION         │
        └─────────────────────────────┘
                  │
                  ▼
            (SHIPPING)
```

# FIG. 16

ION IMPLANTATION — S94

OXIDIZATION — S91

CVD — S92

FORM ELECTRODE — S93

PRE-PROCESSING PROCESS

FORM RESIST — S95

PERFORM EXPOSURE — S96

PERFORM DEVELOPMENT — S97

POST-PROCESSING PROCESS

PERFORM ETCHING — S98

REMOVE RESIST — S99

# FIG. 17

```
( START )
        |
        v
```

MEASURE ABSOLUTE VALUE OF REFRACTIVE INDEX AND REFRACTIVE INDEX DISTRIBUTION OF GLASS MATERIAL — S100

PERFORM MACHINING OF OPTICAL MEMBER (LENS) — S102

MEASURE SHAPE OF MACHINED SURFACE, RADIUS OF CURVATURE AND CENTRAL THICKNESS OF OPTICAL MEMBER — S104

PREDICT BY SIMULATION CHARACTERISTICS OF PROJECTION OPTICAL SYSTEM WHEN ASSEMBLED BY USING MEASURED REFRACTIVE INDEX DISTRIBUTION, SHAPE OF MACHINED SURFACE, RADIUS OF CURVATURE AND CENTRAL THICKNESS — S106

OPTIMIZE SPACES AND INSTALLATION ANGLE OF OPTICAL MEMBER — S108

INCORPORATE OPTICAL MEMBER IN SPLIT LENS-BARREL AS PER SPACES AND INCORPORATION ANGLE OPTIMIZED BY SIMULATION — S110

```
        |
        v
    ( END )
```

# FIG. 18

# FIG. 19A

# FIG. 19B

# FIG. 20

# FIG. 21

# FIG. 22A

# FIG. 22B

# FIG. 22C

## INTERNATIONAL SEARCH REPORT

| International application No. |
| --- |
| PCT/JP01/11363 |

**A. CLASSIFICATION OF SUBJECT MATTER**
Int.Cl$^7$  H01L21/027, G03F7/20, G02B13/24, G02B13/18

According to International Patent Classification (IPC) or to both national classification and IPC

**B. FIELDS SEARCHED**

Minimum documentation searched (classification system followed by classification symbols)
Int.Cl$^7$  H01L21/027, G03F7/20, G02B13/24, G02B13/18

Documentation searched other than minimum documentation to the extent that such documents are included in the fields searched
Jitsuyo Shinan Koho      1926-1996      Toroku Jitsuyo Shinan Koho  1994-2002
Kokai Jitsuyo Shinan Koho  1971-2002      Jitsuyo Shinan Toroku Koho  1996-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2000-249917 A (Nikon Corporation), 14 September, 2000 (14.09.2000), Full text; all drawings   (Family: none) | 1-36 |
| Y | JP 2000-121491 A (Nikon Corporation), 28 April, 2000 (28.04.2000), Full text; all drawings   (Family: none) | 1-36 |
| Y | JP 2000-47103 A (Nikon Corporation), 18 February, 2000 (18.02.2000), Full text; all drawings   (Family: none) | 1-36 |
| Y | JP 10-154657 A (Nikon Corporation), 09 June, 1998 (09.06.1998), Full text; all drawings   (Family: none) | 1-36 |

☐ Further documents are listed in the continuation of Box C.      ☐ See patent family annex.

| | |
| --- | --- |
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>    14 February, 2002 (14.02.02) | Date of mailing of the international search report<br>    26 February, 2002 (26.02.02) |
| Name and mailing address of the ISA/<br>    Japanese Patent Office | Authorized officer |
| Facsimile No. | Telephone No. |

Form PCT/ISA/210 (second sheet) (July 1992)